# EUROPEAN PATENT APPLICATION

(11) **EP 2 317 565 A1**
(43) Date of publication of application: **04.05.2011**
(21) Application number: 10014185.2
(22) Date of filing: 02.11.2010
(51) Int. Cl.: H01L 31/048, H01L 31/052

(54) **Heat dissipation sheet for the back face of solar battery module, and solar battery module using the same**

(30) Priority: 02.11.2009 JP 2009252472
(71) Applicant: Keiwa Inc., Osaka-shi Osaka (JP)
(72) Inventor: Osamura, Keiichi, Kitasaku-gun Nagano (JP); Kobayashi, Toshiro, Kobe-shi Hyogo (JP); Kawashima, Koji, Osaka-shi Osaka (JP)
(74) Representative: Maxton Langmaack & Partner

(57) **Abstract**

A heat dissipation sheet (1) for the back face of a solar battery module includes a heat dissipation film (2), and an adhesive compound layer (3) laminated on one face side of the heat dissipation film. The heat dissipation film preferably has a fine bumpy shape on the entire surface of another face. The heat dissipation film preferably includes a substrate layer (4) in which the adhesive compound layer is laminated on one face side, and a heat dissipation layer (5) laminated on another face side of the substrate layer. The heat dissipation layer preferably includes fine particles (6), and a binder (7) for the fine particles.

## Description

### BACKGROUND OF THE INVENTION

### Field of Invention

The present invention relates to a heat dissipation sheet for the back face of a solar battery module which is provided to attach on the back face of a solar battery module, and is capable of improving a heat dissipation property of the solar battery module.

### Description of the Related Art

In recent years, solar photovoltaic power generation as a clean energy source has attracted attention owing to increasing awareness of environmental issues such as global warming, thereby leading to development of solar batteries having a variety of configurations. This solar battery is produced by packaging a plurality of solar battery cells generally wired in series or in parallel, and is constructed with a plurality of unitized solar battery modules.

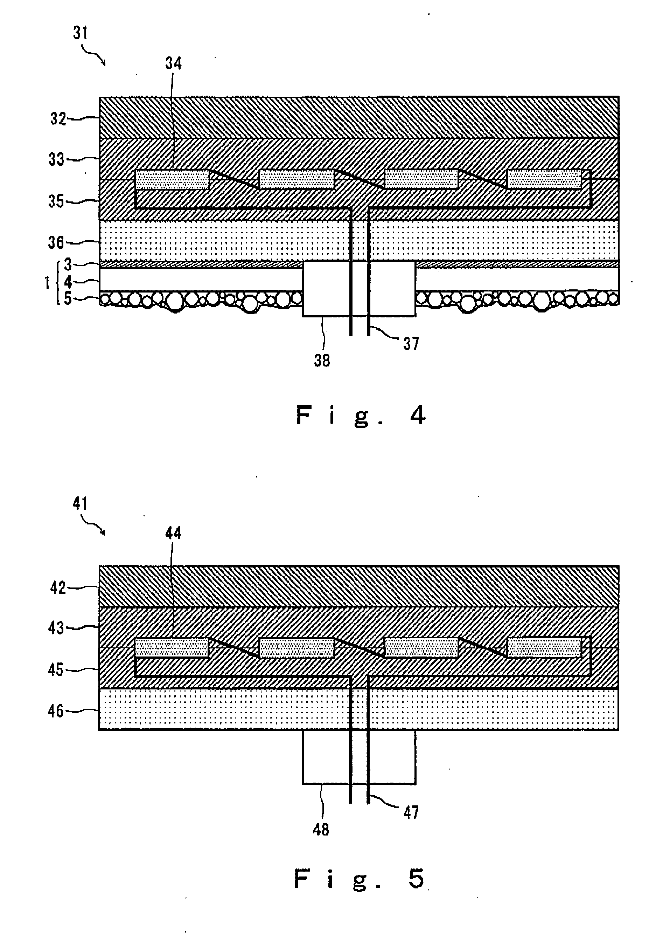

For the aforementioned solar battery modules, sufficient durability, weather resistance and the like for permitting use outdoors for a long period of time are needed. As shown in Fig. 5, in a specific structure of a general solar battery module 41, a light-transmissive substrate 42 consisting of glass or the like, a filler layer 43 consisting of a thermoplastic resin such as an ethylene-vinyl acetate copolymer (EVA) or the like, a plurality of solar battery cells 44 as a photovoltaic device, a filler layer 45 that is similar to the filler layer 43, and a back sheet 46 for the solar battery module which are laminated in this order from the front face side, and molded integrally by a vacuum heat lamination process or the like. Furthermore, solar battery cells 44 are respectively wired serially or in parallel, and terminals 47 of this wiring are connected to an external terminal via a junction box 48 provided on the back face (back sheet 46) side.

When a solar battery module 41 having such a construction is installed outdoors, even at an outside temperature of 20°C, the temperature of the solar battery module 41 is elevated to exceed 50° due to the heat generated accompanying with the operation of the solar battery cells 44 during electric power generation by the solar battery module 41. When the temperature of the solar battery module 41 is thus elevated, disadvantages of deteriorated efficiency of electric power generation occur resulting from temperature characteristics of the solar battery cells 44.

Furthermore, when one among multiple solar battery cells 44 is shaded resulting from a certain structure in the solar battery module 41 during electric power generation, electric power generation of this solar battery cell 44 becomes insufficient, whereby the solar battery cell 44 per se serves as a resistance, and thus a potential difference, which is a product of the resistance value and the electric current that flows, is generated between electrodes of this solar battery cell 44. Accordingly, a bias voltage in the opposite direction is applied to the solar battery cell 44, leading to heat generation of the cell, whereby a state of hot spot is caused, generally referred to. Continuing elevation of the temperature of the solar battery cell 44 by the occurrence of such a hot spot phenomenon results in a disadvantage, i.e., breaking of this solar battery cell 44 is caused, thereby leading to failure in obtaining a predetermined electric power output from this solar battery module 41.

In order to overcome such a disadvantage, techniques of cooling a solar battery module upon occurrence of a hot spot, or temperature elevation of the solar battery module were proposed. For example, a solar battery module provided with a heat dissipation film having a protruding membranous heat dissipation portion on the back face side was proposed (for example, see Japanese Unexamined Patent Application, Publication No. 2000-183375, etc.). However, according to the aforementioned solar battery module, repair of the heat dissipation film surface is difficult once it is damaged, and hydrolysis of the filler layer may be promoted resulting from penetration of water vapor from the damaged portion, whereby useful life of the solar battery cell can be diminished. In addition, since introduction to preexisting solar battery modules is impossible, it cannot contribute to extension of useful life by improving a heat dissipation effect of a solar battery module which had been already put into practical use outdoors. Moreover, there exist significant needs for heat dissipation sheets that achieve more superior heat dissipation effect than preexisting heat dissipation sheets.

### [Prior Art Documents]

### [Patent Documents]

Patent Document 1: Japanese Unexamined Patent Application, Publication No. 2000-183375

### SUMMARY OF THE INVENTION

The present invention was made taking account these disadvantages, and an object of the present invention is to provide a heat dissipation sheet for the back face of a solar battery module, and a solar battery module using the same, the heat dissipation sheet being capable of improving heat dissipation properties of solar battery modules already used and also capable of constantly maintaining a heat dissipation function and the like of solar battery modules by replacement.

An aspect of the present invention made for solving the aforementioned problems is directed to a heat dissipation sheet for the back face of a solar battery module including a heat dissipation film, and an adhesive compound layer laminated on one face side of the heat dissipation film. According to the heat dissipation sheet for the back face of a solar battery module, due to having an adhesive compound layer laminated on one face side, it can be proved to attach to the back face of a conventional solar battery module via the adhesive compound layer. Therefore, heat dissipation properties of conventional solar battery modules can be improved according to the heat dissipation sheet for the back face of a solar battery module, and in turn enhancement of efficiency of electric power generation, and extension of useful life of the solar battery module can be realized. Moreover, since the heat dissipation sheet for the back face of a solar battery module includes an adhesive compound layer laminated on one face side, even when the heat dissipation film of the heat dissipation sheet is damaged, or the heat dissipation property is impaired due to aged deterioration, such a sheet can be easily replaced with a new heat dissipation sheet, whereby a superior heat dissipation property of the solar battery module can be constantly maintained. In addition, According to the heat dissipation sheet for the back face of a solar battery module, when attached to the back face of solar battery module in which physical defects such as cracks have caused resulting from use for a long period of time, and the like, such defects can be filled with the adhesive compound layer. Therefore, the water vapor barrier property of the back face can be improved, and the heat dissipation property can be promoted since the thermal conductivity can be increased by allowing for sealing.

The heat dissipation film may have a fine bumpy shape on the entire surface of another face. Due to having a fine bumpy shape on the entire surface of another face according to the heat dissipation sheet for the back face of a solar battery module, the surface area of the another face significantly increases, thereby enabling improvement of the heat dissipation function.

The heat dissipation film may include a substrate layer in which the adhesive compound layer is laminated on one face side, and a heat dissipation layer laminated on another face side of the substrate layer. When the heat dissipation film has two different layers in this manner, to use a material having a high water vapor barrier property, for example, can be used for the substrate layer or the heat dissipation layer, whereby the heat dissipation sheet for the back face of a solar battery module can have still superior functional properties. In addition, by providing the heat dissipation layer separately, easy formation of the heat dissipation sheet for the back face of a solar battery module is enabled, and formation of the heat dissipation layer meeting desired heat dissipation property can be readily Carried out.

The heat dissipation layer may include fine particles, and a binder for the fine particles. According to the heat dissipation sheet for the back face of a solar battery module, the fine particles enable a fine bumpy shape to be formed easily on the entire surface of the front face (another face of the heat dissipation film) such that a desired shape is provided, and thus heat dissipation property can be improved certainly.

The fine particles may be at least one type of beads selected from metal beads and inorganic oxide beads. According to the heat dissipation sheet for the back face of a solar battery module, by using beads as the fine particles, a fine bumpy shape can be certainly provided on the entire surface of the front face (another face of the heat dissipation film). In addition, since the metal and the inorganic oxide have a high thermal conductivity, the heat dissipation property can be further improved by allowing the heat locally generated to be diffused over the entire face of the sheet.

It is also preferred that the heat dissipation layer includes a vapor-deposited inorganic oxide. According to the heat dissipation sheet for the back face of a solar battery module, the heat dissipation property can be improved by diffusing the heat locally generated to the entire surface of the sheet due to a high thermal conductivity of the inorganic oxide. In addition, since the heat dissipation layer including an inorganic oxide has a superior water vapor barrier function, improvement of resistance to hydrolysis is enabled. Furthermore, when an inorganic oxide having an insulation property is included, the insulation property of the solar battery module can be improved, thereby enabling protection of portions having electric conductivity such as solar battery cells and wirings.

The heat dissipation layer is also preferably a metal foil. According to the heat dissipation sheet for the back face of a solar battery module, the heat dissipation property can be improved by diffusing the heat locally generated to the entire surface of the sheet due to an extremely high thermal conductivity of the metal foil. In addition, since the heat dissipation layer that is a metal foil has a superior water vapor barrier function, improvement of resistance to hydrolysis is enabled.

one face (the face on the side opposite to the face on which the heat dissipation film is laminated) of the adhesive compound layer is preferably covered with a release sheet. Since the heat dissipation sheet for the back face of a solar battery module can prevent the adhesive compound layer from being in contact with others due to the covering of one face with a release sheet, superior workability is maintained until just before the operation of attaching, and the adhesion function of the adhesive sheet in attaching can be improved.

Therefore, according to a solar battery module including a transparent substrate, a filler layer, solar battery cells as a photovoltaic device, a filler layer, a back sheet, and the heat dissipation sheet for the back face of a solar battery module laminated in this order from the front face side, in which the solar battery module is characterized in that the heat dissipation sheet for the back face of a solar battery module is provided to attach via the adhesive compound layer thereof on the back face of the back sheet, the heat dissipation property of the solar battery module can be improved, and improvement of the efficiency of electric power generation and extension of useful life can be achieves.

The term "front face side" of the solar battery module herein means the light-receiving face side of the solar battery module. The term "back face side" means a face opposite to the front face side, i.e., the aforementioned light-receiving face side.

As described in the foregoing, according to the heat dissipation sheet for the back face of a solar battery module of the present invention, by attaching on the back face of solar battery module via the adhesive compound layer, the heat dissipation property of the solar battery module can be improved. As a result, efficiency of electric power generation of the solar battery module can be enhanced, and extension of useful life of the solar battery module can be achieved. Moreover, since the heat dissipation sheet for the back face of a solar battery module of the present invention can be stuck also on the back face of a solar battery module already used, efficiency of electric power generation of the solar battery module already used is improved, and useful life can be extended. Additionally, also in the case in which the defects such as cracks are generated in the back face of a solar battery module thus used, deterioration of the function of the back sheet can be prevented by filling with the adhesive compound layer. Furthermore, the solar battery module of the present invention allows the heat dissipation property to be improved, whereby the efficiency of electric power generation is enhanced, and extension of useful life is enabled.

### [BRIEF DESCRIPTION OF THE DRAWINGS)

Fig. 1 shows a schematic cross sectional view illustrating a heat dissipation sheet for the back face of a solar battery module according to one embodiment of the present invention.
Fig. 2 shows a schematic cross sectional view illustrating a heat dissipation sheet for the back face of a solar battery module according to an embodiment different from the heat dissipation sheet for the back face of a solar battery module shown in Fig. 1.
Fig. 3 shows a schematic cross sectional view illustrating a heat dissipation sheet for the back face of a solar battery module according to an embodiment different from the heat dissipation sheets for the back face of a solar' battery module shown in Fig. 1 and Fig. 2.
Fig. 4 shows a schematic cross sectional view illustrating a solar battery module in which the heat dissipation sheet for the back face of a solar battery module shown in Fig. 1 is used.
Fig. 5 shows a schematic cross sectional view illustrating a conventional and general solar battery module.

### DESCRIPTION OF THE PREFERRED EMBODIMENTS

Hereinafter, the heat dissipation sheet for the back face of a solar battery module of the present invention, and a solar battery module using the same are explained in detail with appropriate references to the drawings

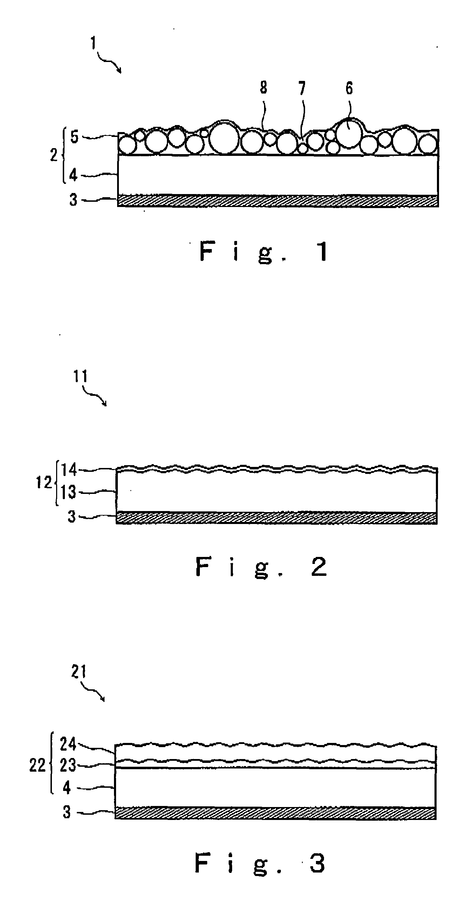

The heat dissipation sheet 1 for the back face of a solar battery module shown in Fig. 1 includes a heat dissipation film 2, and an adhesive compound layer 3 laminated on one face side of the heat dissipation film 2.

The heat dissipation film 2 includes a substrate layer 4 in which the adhesive compound layer 3 is laminated on one face side thereof, and a heat dissipation layer 5 laminated another face side of the substrate layer 4.

The substrate layer 4 is formed using a synthetic resin as a principal component. A synthetic resin included in the substrate layer 4 as a principal component is not particularly limited, and examples thereof include e.g., a polyolefin-derived resin, a fluorine-containing resin, a poly(meth)acrylic resin, a polycarbonate-based resin, a polyester-based resin, a polyamide-based resin, a polyimide-based resin, a polyamideimide-based resin, a polyarylphthalate-based resin, a silicone-based resin, a polysulfone-based resin, a polyphenylenesulfide-based resin, a polyether sulfone-based resin, a polyurethane-based resin, an acetal-based resin, a cellulose-based resin, an acrylonitrile-styrene copolymer (AS resin), an acrylonitrile-butadiene-styrene copolymer (ABS resin), a polyvinyl chloride-based resin, and the like. Among the resins described above, polyolefin-derived resin, polyester-based resin, fluorine-containing resin having high heat resistance, physical strength, weather resistance and durability, and gas barrier properties against water vapor and the like, and the like are preferred.

Examples of the polyolefin-derived resin include polyethylene (e.g., high density polyethylene, low density polyethylene and the like), copolymers of polypropylene, ethylene with an unsaturated carboxylate ester (e.g., ethylene-vinyl acetate copolymer, ethylene-methyl acrylate copolymer, ethylene-methyl methacrylate copolymer and the like), copolymers of ethylene and unsaturated carboxylic acid (e.g., ethylene-acrylic acid copolymer, ethylene-methacrylic acid copolymer and the like), ionomer resins, and the like. Among these, polyethylene that exhibits favorable balance of costs and various functions such ae resistance to hydrolysis, heat resistance, weather resistance and the like, as well as cyclic polyolefin-based resins that are excellent in functional properties such as heat resistance, strength, weather resistance, durability and gas barrier properties.

Examples of the cyclic polyolefin-based resin include e.g., at) polymers obtained by polymerization of cyclic diene such as cyclopentadiene (and a derivative thereof), dicyclopentadiene (and a derivative thereof), cyclohexadiene (and a derivative thereof), norbornadiene (and a derivative thereof) or the like, b) copolymers obtained by copolymerization of one, or two or more of the olefin-based monomers such as ethylene, propylene, 4-methyl-1-pentene, styrene, butadiene and isoprene with the cyclic diene, and the like. Among these cyclic polyolefin-based resins, polymers of cyclic diene such as cyclopentadiene (and a derivative thereof), dicyclopentadiene (and a derivative thereof) or norbornadiene (and a derivative thereof) that are excellent in the strength, heat resistance, weather resistance and the like are particularly preferred.

As the polyester-based resin, for example, polyethylene terephthalate, polyethylene naphthalate, and the like are exemplified. Among these polyester-based resins, polyethylene terephthalate having favorable balance of costs and various functions such as heat resistance, weather resistance etc., is particularly preferred.

As the fluorine-containing resin, for example, polytetrafluoroethylene (PTFE), a perfluoroalkoxy resin (PFA) constituted with a copolymer of tetrafluoroethylene with perfluoroalkylvinyl ether, a copolymer(FEP) of tetrafluoroethylene with hexafluoropropylene, a copolymer (EPE) of tetrafluoroethylene, perfluoroalkylvinyl ether and hexafluoropropylene, a copolymer (ETFE) of tetrafluoroethylene with ethylene or propylene, a polychlorotrifluoroethylene resin (PCTFE), a copolymer (ECTFE) of ethylene with chlorotrifluoroethylene, a vinylidene fluoride-based resin (PVDF), a vinyl fluoride-based resin (PVF), and the like may be exemplified. Among these fluorine-containing resins, a polyvinyl fluoride-based resin (PVF), and a copolymer (ETFE) of tetrafluoroethylene with ethylene or propylene that are superior in strength, heat resistance, weather resistance and the like are particularly preferred.

As the material for forming the substrate layer 4, the aforementioned synthetic resin can be used alone, or as a mixture of two or more thereof. Moreover, a variety of additives can be blended in the material for forming the substrate layer 4 for the purpose of improving and/or modifying the processibility, heat resistance, weather resistance, mechanical properties, dimension accuracy and the like. Examples of the additive include e.g., lubricants, crosslinking agents, antioxidants, ultraviolet ray-absorbing agents, light stabilizers, fillers, reinforcing fibers, strengthening agents, antistatic agents, fire retardants, flame retardants, foaming agents, fungicides, pigment, and the like. The method of molding the substrate layer 4 is not particularly limited, but for example, a known method such as an extrusion method, a cast molding method, a T-die method, a cutting method, an inflation method or the like may be employed. The substrate layer 4 may have either a monolayer structure, or a multilayer structure including two or more layers.

The lower limit of the substrate layer 4 is preferably 12 µm, and particularly preferably 25 µm. On the other hand, the upper limit of the thickness of the substrate layer 4 is preferably 1 mm, and particularly preferably 500 µm.

The substrate layer 4 having a thickness of less than the aforementioned lower limit causes disadvantages such as bringing difficulty in handling of the heat dissipation sheet 1 for the back face of a solar battery module, and an insufficient barrier property against water vapor. In particular, the heat dissipation sheet 1 for the back face of a solar battery module is cut to fit the size of a preexisting solar battery module and to fit the position and the size of junction box of the solar battery module, and thereafter attached to the back face of the solar battery module. Therefore, when the thickness is less than the aforementioned lower limit, workability in cutting and attaching may be deteriorated and thus attaching to meet each solar battery module size may be difficult, or adhesiveness with the adhesiveness may be lowered due to attachment shifted, and may consequently lead to failure in sufficiently exerting the heat dissipation function as the thermal conductivity is lowered.

To the contrary, when the substrate layer 4 has a thickness exceeding the upper limit, demands for reduction in thickness and weight saving of the solar battery module may not be satisfied. In contrast, when the thickness of the substrate layer 4 exceeds the above upper limit, the thermal conductivity is lowered because of the thick substrate layer 4, and heat capacity of the substrate layer 4 and the heat dissipation sheet 1, in turn increases, whereby the heat dissipation efficiency is deteriorated. Further, when the thickness of the substrate layer 4 exceeds the above-described upper limit, the weight of the heat dissipation sheet 1 for the back face of a solar battery module increases, whereby workability in attaching on the back face may be similarly deteriorated and thus attaching to meet each solar battery module size may be difficult, or adhesiveness with the adhesiveness may be lowered due to attachment shifted, and may consequently lead to failure in sufficiently exerting the heat dissipation function as the thermal conductivity is lowered.

The substrate layer 4 may include a pigment dispersed therein. By thus including a pigment dispersed in the substrate layer 4, various characteristics such as heat resistance, weather resistance, durability, thermal dimensional stability, strength and the like of the substrate layer 4, in turn, of the heat dissipation sheet 1 for the back face of a solar battery module can be improved. Further, by including a white pigment dispersed in the substrate layer 4, a function of allowing the rays of light transmitted the solar battery cell to be reflected is added, whereby the power generation efficiency can be further improved. Moreover, design of the solar battery module can be improved by including a black pigment dispersed in the substrate layer 4 to provide a variously colored substrate layer 4.

The white pigment is not particularly limited, but for example, calcium carbonate, titanium oxide, zinc oxide, lead carbonate, barium sulfate or the like can be used. Among them, calcium carbonate is preferred which is excellent in dispersibility in the resin material that forms the substrate layer 4, and which exhibits a comparatively great effect of improving the durability, heat resistance, strength and the like of the substrate layer 4. The calcium carbonate can have a crystal form such as calcite, aragonite, vaterite and the like, and any crystal form is acceptable for use. This calcium carbonate may be subjected to a surface finishing treatment with stearic acid, sodium dodecylbenzenesulfonate, a silane coupling agent, a titanium coupling agent or the like, and impurities such as magnesium oxide, aluminum oxide, silicon dioxide, titanium dioxide and the like may be also included in an amount of approximately 10% or less. Examples of the other pigment include black pigments such as carbon black, blue pigments such as ultramarine and prussian blue, red pigments such as blood red (iron oxide red), cadmium red and molybdenum orange, metal powder pigments that impart metallic luster, and the like, which can be responsible for improvement of the solar battery module design.

The average particle size of the pigment is preferably 100 nm or greater and 30 µm or less, and particularly preferably 300 nm or greater and 3 µm or less. It should be noted that the average particle size referred to herein means an average of particle size of thirty particles randomly extracted from particles observed on an electron microscope at 1,000-fold magnification. In addition, the particle size is defined by means of a Ferret diameter (interval determined when the profile view is sandwiched with parallel lines along a certain direction).

When the average particle size of the pigment is below the above range, uniform dispersion in the substrate layer 4 may be difficult due to the aggregation or the like. In contrast, when the average particle size of the pigment exceeds the above range, the effect of improving various characteristics such as heat resistance for the substrate layer 4 may be decreased.

The lower limit of the content of the pigment is preferably 5% by weight, and particularly preferably 10% by weight. Moreover, the upper limit of the content of the pigment is preferably 60% by weight, and particularly preferably 30% by weight. When the content of the pigment is smaller than the aforementioned lower limit, the effect of improving the durability, heat resistance, strength and the like of the substrate layer 4 may be decreased. In contrast, when the content of the pigment is greater than the aforementioned upper limit, dispersibility of the pigment in the substrate layer 4 may be deteriorated, whereby reduction in strength of the substrate layer 4 may be caused.

The heat dissipation layer 5 includes fine particles 6, and a binder 7 for the fine particles 6. By thus containing fine particles 6 in the heat dissipation layer 5, a fine bumpy shape 8 can be formed uniformly and easily on the entire surface of the heat dissipation layer 5 (another face of the heat dissipation film 2). Thus fine bumpy shape 8 thus provided on the entire surface of the front face (another face of the heat dissipation film 2) of the heat dissipation layer 5 leads to enlargement of the surface area, whereby heat dissipation function from the surface (another face of the heat dissipation film 2) is dramatically enhanced. It should be noted that the average thickness of the heat dissipation layer 5 is not particularly limited, it may be for example, about 5 µm or greater and 1 mm or less.

The fine particles 6 can be generally classified into inorganic particles and organic particles. Specific examples of the inorganic particles which may be used include metal particles of aluminum, iron, an alloy, etc., inorganic oxide such as silicon dioxide, aluminum oxide, zinc oxide and zirconium dioxide, as well as aluminum hydroxide, barium sulfide, magnesium silicate, boron nitride, silicon carbide, silicon nitride, aluminum nitride, zircon silicate and the like, and mixtures thereof. Examples of the specific material which may be used for the organic particles include acrylic resins, acrylonitrile resins, polyurethane, polyvinyl chloride, polystyrene, polyacrylonitrile, polyamide and' the like. Among these, metal particles or inorganic oxide particles having a high thermal conductivity are preferred, metals or metal oxides are particularly preferred, and silicon dioxide and aluminum oxide are still particularly preferred. When the fine particles 6 are metal particles or inorganic oxide particles, the heat generated from solar battery cells transmitted from the side of the substrate layer 4 can be quickly transmitted to the front face (another face of the heat dissipation film 2) side. Therefore, as the heat dissipation property improves, diffusion of locally generated heat over the entire surface of the sheet is enabled, and thus the heat dissipation property can be improved also in this regard.

As the fine particles 6, particle having a comparatively high thermal conductivity and a high electric resistance value are also preferred. When fine particles 6 are such a type of the particles, the heat dissipation property of the sheet can be improved, whereas the electric conductivity can be minimized at a low level; therefore, the voltage endurance can be improved. Such particles may include inorganic nitride such as boron nitride and silicon nitride, and the like.

The shape of the fine particles 6 is not particularly limited, and examples thereof include e.g., spherical, cubic, needle-like, rod-like, spindle, platy, squamous, fibrous and the like. Of these, a spherical shape, i.e., beads shape is preferred which can certainly form fine bumpy easily to give a desired size on the front face (another face of the heat dissipation film 2).

It is preferred that the lower limit of the amount of the light fine particles 6 (incorporated amount per 100 parts of the substrate polymer in the polymer composition being the material for forming the binder 7, which is calculated on the basis of the solid content) be 10 parts, particularly 20 parts, and still more 50 parts, and that the upper limit of the incorporated amount be 500 parts, particularly 300 parts, and still more 200 parts. When the amount of the incorporated fine particles 6 is less than the lower limit described above, formation of the fine bumpy shape 8 on the front face (another face of the heat dissipation film 2) may be insufficient, and the surface area is not enlarged enough, leading to failure in exhibiting prominent heat dissipation effect. Also, since the intervals among fine particles are large (not being adjacent), the heat conduction among the fine particles 6 is impaired, leading to reduction of the heat diffusion speed, and as a result, the heat dissipation property may be deteriorated. On the other hand, when the amount of the incorporated fine particles 6 exceeds the upper limit described above, thermal conductivity and heat dissipation property may be enhanced, but an effect of fixing the fine particles 6 may be impaired.

The lower limit of the average particle size of the fine particles 6 is preferably 100 nm, particularly preferably 3 µm, and still more preferably 10 urn, whereas the upper limit of the average particle size of the fine particles 6 is preferably 1 mm, particularly preferably 400 µm, and still more preferably 100 µm. When the average particle size of the fine particles 6 is less than the lower limit described above, satisfactory formation of the bumpy shape 8 on the front face (another face of the heat dissipation film 2) may be difficult, leading to failure in enlargement of.the surface area, and thus the heat dissipation function is not sufficiently exerted. To the contrary, when the average particle size of the fine particles 6 exceeds the upper limit described above, the thickness of the heat dissipation layer 5 increases, contrary to demands for reduction in thickness and weight saving of solar battery modules.

The binder 7 contains a base polymer as a principal component. The aforementioned substrate polymer is not particularly limited, and examples thereof include e.g., acrylic resins, polyurethane, polyesters, fluorine-based resins, silicone-based resins, polyamide imide, epoxy resins, ultraviolet-curable resins and the like. One or two or more of these polymers may be used as a mixture. Particularly, a highly processable polyol that can be readily formed into the heat dissipation layer 5 by a means such as coating or the like is preferred as the substrate polymer.

Examples of the polyol include e.g., polyols obtained by polymerizing a monomer component including a hydroxyl group-containing unsaturated monomer, polyester polyols obtained under a condition with excess hydroxyl groups present, and the like. These may be used alone or two or more of them may be used as a mixture.

Examples of the hydroxyl group-containing unsaturated monomer include (a) hydroxyl group-containing unsaturated monomers such as e.g., 2-hydroxyethyl acrylate, 2-hydroxypropyl acrylate, 2-hydroxyethyl methacrylate, 2-hydroxypropyl methacrylate, allyl alcohol, homoallyl alcohol, cinnamic alcohol, and crotonyl alcohol, and (b) hydroxyl group-containing unsaturated monomers obtained by a reaction of a dihydric alcohol or an epoxy compound such as e.g., ethylene glycol, ethylene oxide, propylene glycol, propylene oxide, butylene glycol, butylene oxide, 1,4-bis (hydroxymethyl)cyclohexane, phenylglycidyl ether, glycidyl decanoate or PRACCEL FM-1 (manufactured by Daicel Chemical Industries, Ltd.), with an unsaturated carboxylic acid such as e.g., acrylic acid, methacrylic acid, maleic acid, fumaric acid, crotonic acid or itaconic acid. The polyols can be manufactured by polymerizing one or two or more selected from these hydroxyl group-contaiaing unsaturated monomers.

Moreover, the polyol can be also manufactured by polymerizing one or two or more ethylenic unsaturated monomers selected from ethyl acrylate, n-propyl acrylate, isopropyl acrylate, n-butyl acrylate, tert-butyl acrylate, ethylhexyl acrylate, ethyl methacrylate, n-propyl methacrylate, isopropyl methacrylate, n-butyl methacrylate, tert-butyl methacrylate, ethylhexyl methacrylate, glycidyl methacrylate, cyclohexyl methacrylate, styrene, vinyltoluene, acrylic acid, methacrylic acid, acrylonitrile, vinyl acetate, vinyl propionate, vinyl stearate, allyl acetate, diallyl adipate, diallyl itaconate, diethyl maleate, 1-methylotyrene, vinyl chloride, vinylidene chloride, acrylamide, N-methylolacrylamide, N-butoxymethylacrylamide, diacetone acrylamide, ethylene, propylene, isoprene and the like, with the hydroxyl group-containing unsaturated monomer selected from those in the above (a) and (b).

The polymer obtained by polymerizing the monomer component including the hydroxyl group-containing unsaturated monomer may have a number average molecular weight of 1,000 or greater and 500,000 or less, and preferably 5,000 or greater and 100,000 or less. Furthermore, the hydroxyl value may be 5 or greater and 300 or less, preferably 10 or greater and 200 or less, and more preferably 20 or greater and 150 or less.

The polyester polyol obtained under a condition with excess hydroxyl groups being present can be manufactured by allowing a reaction of (c) a polyhydric alcohol such as e.g., ethylene glycol, diethylene glycol, propylene glycol, dipropylene glycol, 1,3-butanediol, 1,4-butanediol, 1,5-pentanediol, neopentyl glycol, hexamethylene glycol, decamethylene glycol, 2,2,4-trimethyl-1,3-pentanediol, trimethylolpropane, hexanetriol, glycerin, pentaerythritol, cyclohexanediol, hydrogenated bisphenol A, bis(hydroxymethyl)cyclohexane, hydroquinone bis (hydroxyethyl ether), tris (hydroxyethyl) isocyanurate or xylylene glycol with (d) a polybasic acid such as e.g., maleic acid, fumaric acid, succinic acid, adipic acid, sebacic acid, azelaic acid, trimellitic acid, terephthalic acid, phthalic acid or isophthalic acid, under a condition in which number of the hydroxyl groups in the polyhydric alcohol such as propanediol, hexanediol, polyethylene glycol, trimethylolpropane or the like is greater than number of the carboxy groups of the aforementioned polybasic acid.

The polymer obtained by polymerizing the monomer component including the hydroxyl group-containing unsaturated monomer may have a number average molecular weight of 500 or greater and 300,000 or less, and preferably 2,000 or greater and 100,000 or less. Furthermore, the hydroxyl value may be 5 or greater and 300 or less, preferably 10 or greater and 200 or less, and more preferably 20 or greater and 150 or less.

The polyol for use as the substrate polymer of the polymer composition may be preferably an acryl polyol which is obtained by polymerizing the aforementioned polyester polyol, and a monomer component comprising the hydroxyl group-containing unsaturated monomer, and which has a (meth)acrylic unit or the like. The binder 7 including the polyester polyol or acryl polyol as the substrate polymer is highly weather-resistant, and impairment of stickiness of the fine particles 6 can be suppressed. Either one of this polyester polyol or the acryl polyol may be used, alternatively, both of them may be used.

The number of the hydroxyl groups in the polyester polyol and the acryl polyols is not particularly limited as long as it is two or more per molecule, however, when the hydroxyl value in the solid content is equal to or less than 10, crosslinking points may be reduced and thus, film physical properties such as solvent resistance, water resistance, heat resistance, surface hardness and the like are likely to be decreased

The adhesive compound layer 3 is formed by coating the adhesive compound on one face of the heat dissipation film 2. The lower limit of the thickness of the adhesive compound layer 3 is preferably 12 µm, particularly preferably 25 µm, and still more preferably 100 µm. In addition, the upper limit of the thickness of the adhesive compound layer 3 is preferably 1 mm, particularly preferably 500 µm, and still more preferably 200 µm.

According to the heat dissipation sheet 1 for the back face of a solar battery module including the adhesive compound layer 3 having the thickness described above, even when the adhesive sheet 1 is laminated on the back sheet surface of the back face of the solar battery module on which scratches and cracks occurred, the back sheet and the heat dissipation sheet 1 can be fully stuck by filling the scratch and crack portions with the adhesive compound, thereby enabling increase of the thermal conductivity. Moreover, according to the heat dissipation sheet, penetration of water vapor and the like is prevented, and expansion of defects such as scratches and cracks can be suppressed. In addition, since the thickness of the adhesive compound layer falls within the above range according to the heat dissipation sheet 1 for the back face of a solar battery module, the adhesive compound layer 3 can be embedded into the deepest portion of the physical scratches and cracks which can usually occur, and expansion of the physical defects such as scratches and cracks can be inhibited, and penetration of water vapor and the like from the outside can be prevented certainly.

When the thickness of the adhesive compound layer 3 is less than the lower limit described above, the adhesive compound cannot fill in the defects such as scratches and cracks having the depth that may usually occur, leading to generation of gaps. Accordingly, evolution of the expansion of the defects is accelerated, and penetration of water vapor and the like from the gap results in deterioration of barrier properties against water vapor and the like. In addition, due to the presence of the gap, the thermal conductivity is lowered, and in turn the heat dissipation efficiency is lowered. To the contrary, when the thickness of the adhesive compound layer 3 exceeds the upper limit described above, workability may be deteriorated such as, for example, interference of operation of cutting to make the heat dissipation sheet 1 have a desired shape because of the thickness of the adhesive compound layer 3. Additionally, since the thermal conductivity is lowered, the heat dissipation efficiency is impaired.

Although the adhesive compound which may be used in the adhesive compound layer 3 is not particularly limited, for example, acrylic adhesive compounds, acrylic rubber-based adhesive compounds, natural rubber-based adhesive compounds, synthetic rubber-based adhesive compounds such as butyl rubber-based compounds, silicone-based adhesive compounds, polyurethane-based adhesive compounds, epoxy-based adhesive compounds, polyethylene-based adhesive compounds, polyester-based adhesive compounds, and the like are exemplified. Of these, acrylic adhesive compounds because of good balance of adhesive force, retentive force and tackiness, as well as favorable durability and weather resistance, and availability at low costs, alternatively, butyl rubber-based adhesive compounds that are favorable in weather resistance, weather resistance and following capability to a bumpy shape are particularly preferred.

Although the monomer that constitutes the acrylic adhesive compound is not particularly limited, examples thereof include: acrylic acid alkyl esters and methacrylic acid alkyl esters (wherein, alkyl group having 1 to 20 carbon atoms, for example) such as methyl acrylate, ethyl acrylate, n-butyl acrylate, methyl methacrylate, isobutyl acrylate, t-butyl acrylate, n-octyl acrylate, isooctyl acrylate, 2-ethylhexyl acrylate, isononyl acrylate, ethyl methacrylate, n-butyl acrylate, isobutyl methacrylate, and 2-ethylhexyl methacrylate; acrylic acid hydroxyalkyl esters and methacrylic acid hydroxyalkyl esters (wherein, hydroxyalkyl group having 1 to 20 carbon atoms, for example) such as 2-hydroxyethyl acrylate, 2-hydroxypropyl acrylate, 4-hydroxybutyl acrylate, 2-hydroxyethyl methacrylate, 2-hydroxypropyl methacrylate, and 4-hydroxybutyl methacrylate; unsaturated aliphatic carboxylic acids such as acrylic acid, methacrylic acid, maleic acid, fumaric acid, and itaconic acid; vinyl acetate; and combinations thereof, and the like. Of these, use of n-butyl acrylate or 2-ethylhexyl acrylate as a monomer is particularly preferred due to favorable adhesion characteristics such as adhesive force, retentive force and tackiness at room temperatures, and since a heat dissipation sheet can be obtained with suppressed squeeze out of the adhesive compound layer inside a printing apparatus. The aforementioned acrylic adhesive compound is produced by allowing such a monomer to be polymerized in the presence of a polymerization initiator by solution polymerization, block polymerization, emulsion polymerization, suspension polymerization or the like with a common method. Particularly, emulsified acrylic adhesive compounds obtained by emulsion polymerization are preferred in attempts to reduce burden to the global environment and in light of safety in producing the adhesive sheet 1, since water is used as a main polymerization solvent.

The butyl rubber-based adhesive compound usually includes a butyl rubber, a softening agent and a tackifier resin.

The butyl rubber is obtained by copolymerization using isobutylene as a principal component, with isoprene in an amount of 1 to 2% by weight for permitting crosslinking. Butyl rubbers are characterized by extremely low gas permeability. The butyl rubber is preferably crosslinked for improving the balance of the adhesive force and the cohesive force, which may be carried out by vulcanization with a polyalkyl phenol resin, electron beam crosslinking, ultraviolet crosslinking carried out by adding a photoinitiator, a photopolymerizable multifunctional monomer (for example, trimethylolpropane triacrylate, etc.), or the like. of these, vulcanization with a polyalkyl phenol resin is preferred because a vulcanization catalyst required for other rubber-based adhesive compounds is not necessary, and favorable heat resistance and anti-staining property are exhibited.

The softening agent is added for the purpose of lowering the glass transition temperature of the butyl rubber to improve an initial adhesion property during a low temperature stage, whereby thereby maintaining superior balance of the cohesive force and the adhesive force. Examples of the softening agent include e. g. , petroleum-based agents such as process oils and extender oils; liquid rubbers such as liquid polyisobutylene, liquid polybutene and liquid polyisoprene; dibasic acid ester-based plasticizers such as dibutylphthalate and dioctylphthalate.

The tackifier resin is added for the purpose of improving an initial adhesion property, and examples thereof include e.g., rosin-based resins such as rosins, modified rosins and rosin asters; terpene-based resins such as terpene resins, aromatic modified terpene resins, hydrogenated terpene resins and terpene phenols; petroleum resins such as aliphatic-based (C5-based) petroleum resins, aromatic (C9-based) petroleum resins, C5/C9-based copolymerized petroleum resins, alicyclic petroleum resins, coumarone indene resins and styrene-based petroleum resins; phenol-based resins such as alkylphenol resins and rosin modified phenol resins; all common tackifier resins such as xylene resins. In light of favorable weather resistance, petroleum resins are preferred.

To the butyl rubber-based adhesive compound may be added, for example, a filler, an anti-aging agent and the like ad libitum within the range to avoid deterioration of the adhesive physical property and the like thereof.

Examples of the filler include e.g., calcium carbonate; magnesium carbonate; calcium such as dolomite; magnesium carbonate; silicic acid salts such as kaolin, calcined clay, pyrophyllite, bentonite, sericite, zeolite, nepheline syenite, talc, attapulgite and wollastonite; silicic acid such as diatomaceous earth and silica flour; aluminum hydroxide; barium sulfate such as pallite and precipitated barium sulfate; calcium sulfate such as gypsum; calcium sulfite; carbon black; zinc oxide; titanium dioxide; and the like.

Examples of the anti-aging agent include e.g., phenol-based anti-aging agents, amine-based anti-aging agents, imidazole-based anti-aging agents, dithiocarbamic acid salt-based anti-aging agents, phosphorus-based anti-aging agents, sulfur ester-based anti-aging agents, and the like.

The adhesive compound that constitutes the adhesive compound layer 3 is preferably an ultraviolet curable adhesive compound. By using an ultraviolet curable adhesive compound as the adhesive compound, the strength of heat dissipation sheet can be enhanced through gradual ultraviolet curing by exposure to solar light after attaching the heat dissipation sheet 1 to a solar battery module.

As the ultraviolet curable adhesive compound, any one containing an ultraviolet curable component in addition to the adhesive polymer component described above may be used, or any one containing an ultraviolet curable polymer having a form in which an unsaturated double bond is added to the side chain of the adhesive polymer may be also used.

As the ultraviolet curable component, any component which causes a reaction by the ultraviolet curable component (for example, a reaction among ultraviolet curable components, a reaction between the ultraviolet curable component and other component in the adhesive compound layer (for example, an acrylic polymer, etc) or the like) upon ultraviolet irradiation may be used. Specifically, as the ultraviolet curable component, a compound such as a monomer, an oligomer or a polymer, having at least one group containing an unsaturated double bond in the molecule (unsaturated double bond-containing group) may be used, and a non volatile compound is particularly suited. The ultraviolet curable component may be used alone, or two or more thereof may be used in combination.

The unsaturated double bond-containing group in the ultraviolet curable component is particularly preferably a group containing a carbon-carbon double bond (carbon-carbon double bond-containing group), and examples of the carbon-carbon double bond-containing group, include e.g., ethylenic unsaturated bond-containing groups such as a vinyl group, allyl groups, and (meth)acryloyl groups, and the like. The unsaturated double bond-containing group may be used alone, or two or more thereof may be used in combination. One molecule of the ultraviolet curable component preferably has the unsaturated double bond-containing group in the number of at least two. When the ultraviolet curable component has at least two unsaturated double bond-containing groups in one molecule, the same unsaturated double bond-containing group may be used in multiple number, or at least two kinds of unsaturated double bond-containing groups may be used.

As the ultraviolet curable component, for example, esterified products of (meth)acrylate and a polyhydric alcohol, ester acrylic compounds, urethane acrylic compounds, cyanurate-based compounds having an unsaturated double bond-containing group, as well as isocyanurate-based compounds having an unsaturated double bond-containing group, and the like may be exemplified.

More specifically, the ultraviolet curable component may be exemplified by, for example, di(meth)acrylates of an alkylene glycol (e.g., (meth)acrylic acid di(alkylene glycol) esters; for example, di(meth)acrylatea of a C1-9 alkylene glycol or a poly(Cl-9 alkylene glycol) such as di(meth)acrylate of tetraethylene glycol, di(meth)acrylate of polyethylene glycol, di(meth)acrylate of propylene glycol, di(meth)acrylate of polypropylene glycol, di(meth)acrylate of 1,4-butylene glycol, dirmath)acrylate of 1,6-hexanediol, di(meth)acrylate of neopentyl glycol, etc.), 2-propenyl-di-3-butenyl cyanurate, di(meth)acrylate of tris(2-hydroxyethyl)isocyanurate, di(meth)acrylates of diols obtained by addition of 4 mol or more ethylene oxide or propylene oxide based on 1 mol of neopentyl glycol, di(meth)acrylates of bisphenol A or a modified product thereof, di(meth)acrylates of trimethylolpropane or a modified product thereof, tri(meth)aCrylates of trimethylolpropane or a modified product thereof, tetramethylolmethane tetra(meth)acxylate, tris(2-hydroxyethyl)isocyanurate tri(meth)acrylate, pentaerythritol tri(meth)acrylate, pentaerythritol tetra(meth)acrylate, poly(meth)aCrylates of dipentaerythritol, caprolactone-modified tris[(meth)acryloxyethyl]isocyanurate, poly(meth) acrylates of alkyl-modified dipentaerythritol, poly(meth)acrylates of caprolactone-modified dipentaerythritol, neopentyl glycol adipate-modified di(meth)acrylate, neopentyl glycol hydroxypivalate di(meth)acrylate, hydroxypivalic acid ester-modified neopentyl glycol di(meth)acrylate, caprolactone-modified neopentyl glycol hydroxypivalate di(meth)acrylate, dioxane-modified di(meth)acrylate, cyclopentanyl di(meth)aorylate, ethylene oxide-modified phosphoric acid di(meth)acrylate, ethylene oxide-modified alkylated phosphoric acid di(meth)acrylate, and the like.

Although the rate of the ultraviolet curable component contained is not particularly limited, for example, it is about 5 to 500 parts by mass; and preferably 10 to 200 parts by mass based on 100 parts by mass of the adhesive polymer component such as an acrylic resin.

It is to be noted that the ultraviolet curable adhesive compound may be blended with additives such as a photopolymerization initiator and a crosslinking agent as needed in addition to the adhesive polymer component and the ultraviolet curable component.

The photopolymerization initiator is not particularly limited as long as it is a photopolymerization initiator which can be activated by an ultraviolet ray, and can cause a reaction of the ultraviolet curable component. Specific examples of the photopolymerization initiator which may be used include e.g., acetophenone-based photopolymerization initiators, benzoin-based photopolymerization initiators, benzyl-based photopolymerization initiators, benzoinalkyl ether-based photopolymerization initiators, benzophenone-based photopolymerization initiators, ketal-based photopolymerization initiators, thioxanthone-based photopolymerization initiators, a-ketol-based photopolymerization initiators, aromatic sulfonyl chloride-based photopolymerization initiators, photoactive oxime-based photopolymerization initiators, and the like. The photopolymerization initiator may be used alone, or two or more thereof may be used in combination.

As the photopolymerization initiator, an acetophenone-based photopolymerization initiator, or a benzoin-based photopolymerization initiator is suitable. Examples of the acetophenone-based photopolymerization initiator include e.g., 4-phenoxydichloroacetophenone, 4-t-butyl-dicliloroacetophenone, diethoxyacetophenone, 1-phenyl-2-hydroxy-2-methylpropane-1-one, 1-[4-(2-hydroxyethyl)-phenyl]-2-hydroxy-2-methylpropane-1-one 1-hydroxycyclohexyl phenyl ketone, and the like. As the benzoin-based photopolymerization initiator, for example, benzoin and the like may be exemplified.

In addition, the benzyl-based photopolymerization initiator includes, for example, benzyl and the like. Examples of the benzoinalkyl ether-based photopolymerization initiator include e.g., benzoinmethyl ether, benzoinethyl ether, benzoinpropyl ether, benzoinisopropyl ether, benzoinisobutyl ether, and the like. Examples of the benzophenone-based photopolymerization initiator include e.g., benzophenone, benzoylbenzoic acid, 3,3 dimethyl-4-methoxybenzophenone, polyvinylbenzophenone, α-hydroxycyclohexylphenyl ketone, and the like. Examples of the ketal-based photopolymerization initiator include e.g., benzyldimethyl ketal, and the like. Examples of the thioxanthone-based photopolymerization initiator include e.g., thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, 2,4-diisopropylthioxanthone, dodecylthioxanthone, and the like.

Moreover, as the crosslinking agent, for example, a polyisocyanate-based crosslinking agent, a melamine resin, a urea resin, an aziridine-based compound, an epoxy-based crosslinking agent such as an epoxy resin, a low-molecular compound having multiple carboxyl groups, or an anhydride thereof, a polyamine, a polymer having multiple carboxyl groups, or the like may be used.

Since the heat dissipation sheet 1 for the back face of a solar battery module includes an adhesive compound layer 3 laminated on one face side thereof, it can be directly attached to the back face of a conventional solar battery module. Accordingly, it improves the heat dissipation property of conventional solar battery modules, and in turn can enhance the efficiency of electric power generation and extend useful life of the solar battery module thereof. In addition, since the heat dissipation sheet 1 for the back face of a solar battery module includes an adhesive compound layer 3 laminated on one face side thereof, even when another face of the heat dissipation sheet is scratched, or the heat dissipation property is impaired due to aged deterioration, the heat dissipation sheet 1 can be easily replaced with new one, whereby a superior heat dissipation property of the solar battery module can be constantly maintained. Moreover, when the heat dissipation sheet 1 for the back face of a solar battery module is attached to the back face of solar battery module in which defects such as cracks are generated, the defects can be filled with the adhesive compound layer 3; therefore, the water vapor barrier property of the back face can be improved. Additionally, because sealing can further elevate the thermal conductivity, promotion of the heat dissipation property is enabled. Furthermore, since the heat dissipation sheet 1 for the back face of a solar battery module has a heat dissipation layer 5 including fine particles 6 and a binder 7, the fine bumpy shape 8 on the front face (another face of the heat dissipation film 2) results in enlargement of the surface area, whereby the heat dissipation effect can be improved.

A heat dissipation sheet 11 for the back face of a solar battery module shown in Fig. 2 includes a heat dissipation film 12, and an adhesive compound layer 3 laminated on one face side of the heat dissipation film 12. Since the adhesive compound layer 3 is similar to that of the heat dissipation sheet 1 for the back face of a solar battery module shown in Fig. 1, explanation thereof will be omitted through designating the identical number.

The heat dissipation film 12 includes a substrate layer 13 in which the adhesive compound layer 3 is laminated on one face side, and a heat dissipation layer 14 laminated on another face side of the substrate layer 13.

Although the material for formation, the average thickness and the like of the substrate layer 13 are, average thickness are similar to those of the substrate layer 4 in the heat dissipation sheet 1 for the back face of a solar battery module shown in Fig. 1, a fine bumpy shape is formed on the entire surface of another face (the surface without the adhesive compound layer 3 laminated) of the substrate layer 13.

The lower limit of the surface roughness (Ra) of another face (the face on which the fine bumpy shape has been formed) of the substrate layer 13 is preferably 1 µm, and particularly preferably 10 µm. On the other hand, the upper limit of the surface roughness (Ra) of the face of the substrate layer 13 on which the fine bumpy shape has been formed is preferably 1 mm, and particularly preferably 100 µm. Note that "surface roughness (Ra)" herein means a value as measured in accordance with JIS-B0601-1994, with a cutoff value of 8 mm, and an evaluation length of 40 mm.

By providing the heat dissipation layer 14 on another face (the face on which the fine bumpy shape has been formed) of the substrate layer 13 having such a surface roughness, the surface area of the heat dissipation layer 14 is enlarged, leading to significant improvement of the heat dissipation effect. When the surface roughness of another face (the face on which the fine bumpy shape has been formed) of the substrate layer 13 is less than the lower limit described above, the fine bumpy shape of the surface is not sufficiently formed when the heat dissipation layer 14 is provided, whereby the surface area cannot be enlarged satisfactorily. To the contrary, the surface roughness of the face of the substrate layer 13 on which the fine bumpy shape has been formed exceeding the upper limit described above results in a rough surface, whereby executing uniform vapor deposition may be difficult, and the surface becomes more likely to be scratched.

The method for molding the substrate layer 13 is not particularly limited as long as the substrate layer 13 having then aforementioned structure can be formed, and various methods may be employed. As the method for producing the substrate layer 13, a method in which a bumpy shape is formed on the surface of a molded sheet, and a method of integral molding with sheet formation and bumpy shape formation may be employed. Specific methods are as follows:
(a) a method of forming the substrate layer 13 including laminating a resin material for formation onto a sheet mold having a shape reversal to the bumpy shape of the front face of the substrate layer 13, and stripping the sheet mold;
(b) a method of injection molding including injecting a melted resin material for formation into a die having a shape reversal to the bumpy shape of the front face of the substrate layer 13;
(c) a method including reheating the resin material for formation which had been formed into a sheet, sandwiching between a metal plate and a die similar to one described above, and pressing to transcribe the shape;
(d) a method of extrusion molding of a sheet including allowing a resin material for formation in a molten state to pass through a nip between a roll mold having on the circumference a shape reversal to the bumpy shape of the front face of the substrate layer 13, and other roll to transcribe the shape; and
(e) a method of forming the substrate layer 13 including providing a bumpy shape on the front face by sand blasting on the sheet surface.

The heat dissipation layer 14 includes a vapor-deposited inorganic oxide. since the heat dissipation layer 14 includes an inorganic oxide, the heat dissipation property can be improved by diffusing the heat locally generated from the solar battery cell, etc., to the entire surface of the sheet due to a high thermal conductivity of the inorganic oxide. In addition, since the heat dissipation layer 14 including an inorganic oxide has a superior water vapor barrier function, improvement of resistance to hydrolysis is enabled.

The means for the vapor deposition of the inorganic oxide is not particularly limited as long as vapor deposition of the inorganic oxide is executed without causing deterioration of the synthetic resin substrate layer 13 such as contraction and the like. Examples of the applicable means include (a) physical vapor deposition (PVD) such as vacuum evaporation, sputtering, ion plating, ion cluster beam methods and the like, and (b) chemical vapor deposition (CVD) such as plasma chemical vapor deposition, thermal chemical vapor deposition, photochemical vapor deposition and the like. Among these vapor deposition, vacuum evaporation and ion plating are preferred which enable formation of the heat dissipation layer 14 having high quality with high productivity.

The inorganic oxide that constitutes the heat dissipation layer 14 is not particularly limited as long as it has high thermal conductivity, and for example, a metal oxide such as aluminum oxide, silica oxide, titanium oxide, zirconium oxide, zinc oxide, tin oxide, magnesium oxide or the like may be used. Of these, aluminum oxide or silica oxide is particularly preferred because of favorable balance of costs and gas barrier properties in addition to high thermal conductivity.

The lower limit of the average thickness of the heat dissipation layer 14 is preferably 3 A, and particularly preferably 400 Å. In contrast, the upper limit of the average thickness of the heat dissipation layer 14 is preferably 3,000 Å, and particularly preferably 800 Å. When the average thickness of the heat dissipation layer 14 is less than the aforementioned lower limit, the gas barrier property that is one of advantages of forming the heat dissipation layer 14 with an inorganic oxide is likely to be deteriorated. To the contrary, when the average thickness of the heat dissipation layer 14 is greater than the aforementioned upper limit, less flexibility of the heat dissipation layer 14 is achieved, whereby defects such as cracking are likely to occur.

In addition, the heat dissipation layer 14 may be formed by vapor deposition of aluminum. When the heat dissipation layer 14 is formed by vapor deposition of aluminum, heat dissipation function is particularly improved according to the heat dissipation sheet 1, and rays of light passed through the solar battery cell reflect and subjected to recycling due to the aluminum vapor deposition surface having metal gloss, whereby efficiency of electric power generation can be promoted.

As the method for forming the heat dissipation layer 14 by vapor deposition of aluminum, a method similar to the vapor deposition method of the inorganic oxide described above may be used. When the heat dissipation layer 14 is formed by vapor deposition of aluminum, the lower limit of the average thickness of the heat dissipation layer 14 is preferably 10 nm, and particularly preferably 20 nm. On the other hand, the upper limit of the thickness of the heat dissipation layer 14 formed by aluminum vapor deposition is preferably 200 nm, and particularly preferably 100 nm. When the thickness of the heat dissipation layer 14 is less than the aforementioned lower limit, the thermal conductivity and gas barrier properties may not be sufficiently exhibited. To the contrary, when the heat dissipation layer 14 has a thickness exceeding the aforementioned upper limit, defects such as cracks are more likely to be generated in the heat dissipation layer 14.

The heat dissipation layer 14 may have either a monolayer structure, or a multilayer structure including two,or more layers. By the formation of the heat dissipation layer 14 having a multilayer structure, deterioration of the substrate layer 13 can be minimized through reduction of thermal burden applied during the vapor deposition, and further, adhesion properties between the substrate layer 13 and the heat dissipation layer 14 can be improved. In addition, conditions of the vapor deposition employed in the aforementioned physical vapor deposition and chemical vapor deposition may be arbitrarily determined depending on the resin type of the substrate layer 13, the thickness of the heat dissipation layer 14, and the like.

In addition, the heat dissipation layer 14 may be formed by a sol-gel method using a composition containing a metal alkoxide and/or a hydrolysate thereof. By forming the heat dissipation layer 14 with such a sol-gel method, adhesiveness with the substrate layer 13 is enhanced, whereby gas barrier properties can be exerted in addition to a high thermal conductivity. Additionally, the heat dissipation layer 14 can be formed at a comparatively low temperature by employing the sol-gel method in which the temperature is not elevated so high as in accordance with vapor deposition. Therefore, since a burden is less likely to be imposed to the substrate layer 13 which is not comparatively resistant to high temperatures, heat dissipation layer 14 having multi layers can be easily formed.

The metal included in the metal alkoxide is exemplified by trivalent or higher valent metals such as e.g., transition metals, rare-earth metals, metals in Groups 3 to 5 in the periodic table, and metals belonging to Group 3B or Group 4 in the periodic table are preferred. The metals belonging to Group 3B in the periodic table include, for example, A1 and the like. The metals belonging to Group 4 in the periodic table include, for example, Ti and Zr belonging to Group 4A, as well as Si belonging to Group 4B, and the like. Among these metals, because a film can be easily formed with a sol-gel method and a superior planarizing function of boundary surfaces is exhibited, A1 and Si are preferred and Si is particularly preferred.

Examples of the alkoxy group included in the metal alkoxide' include e.g., a methoxy group, an ethoxy group, a propoxy group, an isopropoxy group, a butoxy group, an isobutoxy group, a pentyloxy group, a hexyloxy group, and the like. Of these, lower alkoxy groups having 1 to 4 carbon atoms that are superior in hydrolytic polymerizability are preferred, and a methoxy group, an ethoxy group, and a propoxy group are particularly preferred. In addition, for the purpose of promoting hydrolytic polymerizability, a metal alkoxide having at least two alkoxy groups is preferred.

The metal alkoxide may have a hydrocarbon group. Examples of the hydrocarbon group include e.g., alkyl groups such as a methyl group, an ethyl group, a propyl group, an isopropyl group, a butyl group, a pentyl group, and a hexyl group; cycloalkyl groups such as a cyclopentyl group, a cyclohexyl group, and a cyclooctyl group; aryl groups such as a phenyl group, and a naphthyl group; aralkyl groups such as a benzyl group, and a 2-phenylethyl group, and the like. Among these hydrocarbon groups, alkyl groups and aryl groups are preferred. Of these alkyl groups, lower alkyl groups having 1 to 4 carbon atoms are preferred, and a methyl group, an ethyl group and a propyl group are particularly preferred. In addition, of the aryl groups, a phenyl group is preferred. The number of hydrocarbon groups in the metal alkoxide may be selected appropriately depending on the number of the alkoxy groups, and is, in general, about 0 to 2 in one molecule.

Specifically, the metal alkoxide is preferably one represented by the following formula (1):

(R¹)ₘM(OR²)_{X-m} (1)

in the above formula (1): R¹ represents an alkyl group, a cycloalkyl group, an aryl group or an aralkyl group, which may have a substituent; R² represents a lower alkyl group; R¹ and R² may be different depending on "m"; M represents a trivalent or higher valent metal; X represents the valence of the metal M; m represents an integer of 0 to 2; and the difference (X - m) is no less than 2.

In particular, the metal alkoxide in which the metal is Si is preferably represented by the following formula (2):

(R¹)ₙSi(OR²)₄₋ₙ (2)

in the above formula (2): R¹ represents an alkyl group or an aryl group, which may have a substituent; R² represents a lower alkyl group; R¹ and R² may be different depending on "n"; and n represents an integer of 0 to 2.

Specific examples of the metal alkoxide, in which the metal is Al include trimethoxyaluminate, triethoxyaluminate, ethyldiethoxyaluminate, tripropoxyaluminate, and the like.

Specific examples of the metal (Si)alkoxide represented by the above formula (2) includes tetramethoxysilane, methyltrimethoxysilane, ethyltrimethoxysilane, propyltrimethoxysilane, butyltrimethoxysilane, tetraethoxysilane, methyltriethoxysilane, ethyltriethoxysilane, propyltriethoxysilane, butyltriethoxysilane, tetrapropoxysilane, methyltripropoxysilane, ethyltripropoxysilane, dimethyldimethoxysilane, diethyldimethoxysilane, dipropyldimethoxysilane, dimethyldiethoxysilane, diethyldiethoxysilane, γ-chloropropyltrimethoxysilane, γ-chloropropyltriethoxysilane, γ-mercaptopropyltrimethoxysilane, γ-mercaptopropyltriethoxysilane, γ-aminopropyltrimethoxysilane, γ-aminopropyltriethoxysilane, phenyltrimethoxysilane, phenyltriethoxysilane, phenyltripropoxysilane, diphenyldimethoxysilane, diphenyldiethoxysilane, and the like.

Among the metal (Si)alkoxide represented by the above formula (2), compounds having 0 to 2 alkyl group(s) or aryl group(s) having about 1 to 4 carbon atoms, and 2 to 4 alkoxy groups having about 1 to 3 carbon atoms, for example, tetramethoxysilane, methyltrimethoxysilane, ethyltrimethoxysilane, methyltriethoxysilane, tetraethoxysilane, ethyltriethoxysilane, diethyldiethoxysilane, dimethyldiethoxysilane, phenyltrimethoxysilane, phenyltriethoxysilane, and the like are particularly preferred.

In the aforementioned composition, the same type or different type of the metal alkoxide may be used alone or as a mixture of two or more thereof. Moreover, in the composition, monoalkoxysilane in which n is 3 may be added for adjusting hardness and flexibility of the composition, and the like. Furthermore, a compound of a Group 5B element such as, for example, a phosphorus-based compound such as a methyl phosphonous dimethyl ester, ethyl phosphonous dimethyl eater, trichloromethyl phosphonous diethyl ester, methyl phosphonous diethyl ester, methyl phosphonic dimethyl ester, phenyl phosphonic dimethyl ester, or phosphoric acid trialkyl ester, or a boron compound such as boric acid trialkyl ester may be added to the composition described above. Moreover, an alkaline earth metal compound having at least one hydrolyzable organic group may be added as needed to the composition described above. This alkaline earth metal compound may have both the hydrocarbon group and the hydrolyzable organic group.

In the aforementioned composition, a metal alkoxide (A) having a functional group containing at least one of nitrogen, oxygen, sulfur and halogen may be contained. By applying and curing such a composition containing the metal alkoxide (A) having a functional group containing at least one of nitrogen, oxygen, sulfur and halogen, a specific polysiloxane structure is exhibited in the heat dissipation layer 14, and the film physical properties and in turn, heat dissipation property and gas barrier property of the heat dissipation layer 14 can be improved. Still more, the temperature dependency of the gas barrier property of the heat dissipation layer 14 can be reduced.

As the functional group containing at least one of nitrogen, oxygen, sulfur and halogen, for example, an amino group, a chlorine atom, a mercapto group, a glycidoxy group and the like may be exemplified. Examples of the metal alkoxide (A) having the functional group containing at least one of nitrogen, oxygen, sulfur and halogen include e.g., γ-chloropropyltrimethoxysilane, β-(3,4-epoxycyclohexyl)ethyltrimethoxysilane, γ-glycidoxypropyltrimethoxysilane, γ-glycidoxypropylmethyldimethoxysilane, γ-mercaptopropyltrimethoxysilane, N-β(aminoethyl)-γ-aminopropyltrimethoxysilane, N-β(aminoethyl)-γ-aminopropylmethyldimethoxysilane, γ-ureidepropyltriethoxysilane, bis(β-hydroxyethyl)-γ-aminopcopyltriethoxysilane, γ-aminopropylsilicone, and the like, and either one, or at least two of these metal alkoxides may be used.

The content of the metal alkoxide (A), i.e., the content in the composition based on the entire metal alkoxide is preferably 1% by weight or greater and 50% by weight or less, and particularly preferably 3% by weight or greater and 30% by weight or less. When the content of the metal alkoxide (A) falls within the above range, a polysiloxane structure that is responsible for the heat dissipation property and gas barrier property can be provided on the heat dissipation layer 14.

In the aforementioned composition, a solvent-soluble polymer may be contained. By forming the heat dissipation layer 14 according to the sol-gel method using a composition containing such a polymer soluble in the solvent and the metal alkoxide, film physical properties of the heat dissipation layer 14 are improved, and the heat dissipation property and gas barrier property (particularly, heat dissipation properties and gas barrier properties under conditions with high temperatures) of the heat dissipation layer 14 can be further enhanced.

As the aforementioned solvent-soluble polymer, polymers having any of a variety of functional groups or functional binding groups (for example, a hydroxyl group, a carboxyl group, an ester bond, an ether bond, a carbonate bond, an amide group, an amide bond, etc.), polymers having a glycidyl group, halogen-containing polymers, and derivatives from these polymers, and the like are exemplified. These functional group or functional binding groups may be present either in the main chain or the side chain of the polymer. The solvent-soluble polymer may be either a thermoplastic resin or a thermosetting resin, which may be used either alone or as a mixture of two or more thereof. In addition, although the solvent-soluble polymer may be either inert or active for the reaction with the metal alkoxide, a nonreactive polymer is generally employed. The term "amide bond" herein referred to is not limited to "-NHC(O)-" but falls under a concept including a >NC(O)- bond unit.

Examples of the aforementioned polymer having a hydroxyl group and a derivatives thereof include e.g., polyvinyl alcohols, polyvinyl acetals, ethylene-vinyl alcohol copolymers, phenol resins, methylolmelamine and the like, and derivatives thereof (for example, acetalized products, hexamethoxymethylmelamine, etc.). Examples of the aforementioned polymer having carboxyl and derivatives thereof include e.g., homopolymers or copolymers including polymerizable unsaturated acid units such as poly(meth)acrylic acid, maleic anhydride and itaconic acid, and esterified products of these polymers. Examples of the aforementioned polymer having an ester bond include e.g., homopolymers or copolymers including units of a vinyl ester such as vinyl acetate, a (meth)acrylic ester such as methyl methacrylate (for example, polyvinyl acetate, ethylene-vinyl acetate copolymers, (meth)acrylic resins, etc.), saturated polyesters, unsaturated polyesters, vinyl ester resins, diallyl phthalate resins, cellulose esters, and the like. Examples of the polymer having an ether bond include e.g., polyalkylene oxides, polyoxyalkylene glycols, polyvinyl ethers, silicon resins, and the like. Examples of the aforementioned polymer having a carbonate bond include polycarbonates such as bisphenol A type polycarbonates.

Examples of the aforementioned polymer having an amide bond include e.g., N-acylated products such as polyoxazoline having a >N(COR)- bond, and polyalkyleneimine; polyvinylpyrrolidone having a >NC(O)- bond and derivatives thereof; polyurethane having a urethane bond -HNC(O)O-; polymers having a urea bond -HNC(O)NH-; polymers having an amide bond -C(O)XH-; polymer having a biuret linkage; polymer having an allophanate linkage; and the like. In the above formula representing the binding, R represents a hydrogen atom, an alkyl group which may have a substituent, or an aryl group which may have a substituent.

In the case of polyoxazoline having a >N(COR)- bond, the alkyl group represented by R may include, for example, an alkyl group having about 1 to 10 carbon atoms, preferably a lower alkyl group having 1 to 4 carbon atoms, and particularly, a methyl group, an ethyl group, a propyl group, an isopropyl group, or the like. The substituent of the alkyl group includes, for example, a halogen atom such as fluorine, chlorine or bromine, a hydroxyl group, an alkoxy group having about 1 to 4 carbon atoms, a carboxyl group, an alkoxycarbonyl group with an alkyl moiety having about 1 to 4 carbon atoms, and the like. Examples of the aryl group include e.g., phenyl, naphthyl groups, and the like. Examples of the substituent of the aryl group include'e.g., the aforementioned halogen atoms, alkyl groups having about 1 to 4 carbon atoms, a hydroxyl group, alkoxy groups having about 1 to 4 carbon atoms, a carboxyl group, alkoxycarbonyl groups with an alkyl moiety having about 1 to 4 carbon atoms, and the like.

Examples of the oxazoline include e.g., 2-oxazoline, 2-methyl-2-oxazoline, 2-ethyl-2-oxazoline, 2-propyl-2-oxazoline, 2-isopropyl-2-oxazoline, 2-butyl-2-oxazoline, 2-dichloromethyl-2-oxazoline, 2-trichloromethyl-2-oxazoline, 2-pentafluoroethyl-2-oxazoline, 2-phenyl-2-oxazoline, 2-methoxycarbonylethyl-2- oxazoline, 2-(4-methylphenyl)-2-oxazoline, 2-(4-chlorophenyl)-2-oxazoline, and the like. In particular, 2-oxazoline, 2-methyl-2-oxazoline, 2-ethyl-2-oxazoline and the like are preferred. Polymers of such oxazoline may be used either alone, or as a mixture of two or more thereof. The polyoxazoline may be either a homopolymer or a copolymer. In addition, the polyoxazoline may be a copolymer in which polyoxazoline grafted to the polymer.

The polyoxazoline is obtained by ring-opening polymerization of oxazoline which may have a substituent in the presence of a catalyst. As the catalyst, for example, a sulfuric acid ester or a sulfonic acid ester such as dimethyl sulfate, or p-toluenesulfonate alkyl ester; a halogenated alkyl such as alkyl iodide (for example, methyl iodide); metal fluoride among Friedel-Crafts catalysts; an acid such as sulfuric acid, hydrogen iodide or p-toluenesulfonic acid, or an oxazolinium salt which is a salt formed with such an acid and oxazoline, or the like may be used.

Examples of the acylated product of polyalkyleneimine include polymers corresponding to the aforementioned polyoxazoline such as e.g., polymers having an N-acylamino group such as N-acetylamino or N-propionylamino. The polyvinylpyrrolidone and derivatives thereof include polymers of vinylpyrrolidone which may have a substituent, for example, polyvinylpyrrolidone, and the like. Examples of the polyurethane having a urethane bond include e.g., polyurethanes produced by a reaction of a polyisocyanate (tolylenediisocyanate, hexamethylenediisocyanate, etc.) with a polyol (a polyhydric alcohol such as ethylene glycol, propylene glycol, tetramethylene glycol or glycerin; a polyether polyol such as diethylene glycol, polyethylene glycol, dipropylene glycol, or polypropylene glycol; a polyester polyol, or the like). Examples of the polymer having a urea bond include e.g., polymers produced by a reaction of polyurea, polyisocyanate and polyamine (for example, a diamine such as ethylene diamine, diethylene triamine).

Examples of the polymer having an amide bond include polyamide, poly(meth)acrylamide, polyamino acid, and the like. The polymer having an amide bond is preferably a polymer of oxazoline which may have a substituent, an N-acylated product of polyalkyleneimine, polyvinylpyrrolidone, polyurethane, polyamide, poly(meth)acrylamide, and the like. Examples of the polymer having a biuret linkage include polymers produced by a reaction of the polyisocyanate with a compound having a urethane bond. Examples of the polymer having an allophanate linkage include polymers produced by a reaction of the polyisocyanate with a compound having a urea bond, and the like. Examples of the polymer having a glycidyl group include e.g., epoxy resins, homopolymers or copolymers of glycidyl (meth)acrylate, and the like. Examples of the halogen-containing polymer include e.g., polyvinyl chloride, vinyl chloride-vinyl acetate copolymers, vinylidene chloride-based polymers having a vinylidene chloride unit, chlorinated polypropylene, and the like.

The solvent-soluble polymer is, in general, soluble in water; alcohols such as methanol, ethanol, propanol, isopropanol, butanol and cyclohexanol; aliphatic hydrocarbons such as hexane and octane; alicyclic hydrocarbons such as cyclohexane; aromatic hydrocarbons such as benzene, toluene and xylene; halogenated hydrocarbons such as methyl chloride, methylene chloride, chloroform and trichloroethylene; esters such as methyl acetate, ethyl acetate and butyl acetate; ketones such as acetone and methyl ethyl ketone; ethers such as diethyl ether, dioxane, dimethoxy ethane and tetrahydrofuran; nitrogen-containing solvents (for example, N-methylpyrrolidone, nitriles such as acetonitrile, amides such as dimethyl formamide and dimethylacetamide, etc.) as well as aprotic polar solvents such as sulfoxides (for example, dimethyl sulfoxide, etc.); or mixed solvents of the same.

As the solvent-soluble polymer, those having a group capable of forming a hydrogen bond such as e.g., a hydroxyl group, a carboxyl group, an amide group, an amide bond, a nitrogen atom or the like are preferred. When such a solvent-soluble polymer having a group capable of forming a hydrogen bond is used, the solvent for the metal alkoxide and/or a hydrolysate thereof may often be one that is in common, and it is believed that the hydroxyl group of the organic metal polymer produced by hydrolytic polymerization of the metal alkoxide forms a hydrogen bond with a functional group and/or a binding group of the solvent-soluble polymer, and consequently forms a uniform organic-inorganic hybrid thereby enabling a transparent coating film which is uniform at the micro level to be formed.

In addition, as the solvent-soluble polymer, an alcohol-soluble polymer is preferred since a solvent common with that for the metal alkoxide can be used. The alcohol-soluble polymer is preferably a water-soluble polymer such as a polymer having a hydroxyl group, and particularly preferably a polymer having a nitrogen atom (for example, the polymer having an amide bond described above).

The content of the solvent-soluble polymer based on 100 parts by mass of the metal alkoxide (including a hydrolysate thereof) is preferably 40% by weight or greater and 90% by weight or less, and particularly preferably 50% by weight or greater and 80% by weight or less. When the content of the solvent-soluble polymer is below the above range, the effect of improving the heat dissipation properties and gas barrier properties is deteriorated, and formation of a uniform a coating film with a complex of the inorganic polymer and the organic polymer may be difficult. On the other hand, when the content of the solvent-soluble polymer is beyond the above range, the film formability and the uniformity are likely to be improved, and the heat dissipation properties and gas barrier properties may be deteriorated.

In the composition described above, an organic solvent is generally blended. As the organic solvent, an inert appropriate solvent for the polymerize reaction depending on the type of the metal alkoxide, such as for example, an alcohol, an aromatic hydrocarbon, an ether, a nitrogen-containing solvent, a sulfoxide, or a mixed solvent thereof, or the like may be used. Alternatively, the aforementioned solvent-soluble polymer may be also used as the organic solvent. This organic solvent is preferably a solvent that is miscible with the solvent for the metal alkoxide, and is particularly preferably a good solvent that is common for both the solvent-soluble polymer and the metal alkoxide.

In addition, the composition may contain a curing catalyst, and hydrolytic polymerization of the metal alkoxide may be carried out in the presence of the curing catalyst. As the curing catalyst, a tertiary amine or an acid catalyst which is substantially insoluble in water, and soluble in an organic solvent, or the like is used. Examples of the tertiary amine include e.g., N,N-dimethylbenzylamine, tripropylamine, tributylamine, tripentylamine, and the like. Examples of the acid catalyst include inorganic acids such as e.g., hydrochloric acid, sulfuric acid, nitric acid, and phosphoric acid; organic acids such as e.g., carboxylic acids such as formic acid, acetic acid, trichloroacetic acid, trifluoroacetic acid and propionic acid, sulfonic acids such as methanesulfonic acid, ethanesulfonic acid and p-toluenesulfonic acid, and the like.

In the composition for forming the heat dissipation layer 14 by a sol-gel method may be blended as needed a variety of additives such as a plasticizer, an antioxidant, an ultraviolet ray absorbing agent, a fire retardant, an antistatic agent, a surfactant, a filler, a colorant, and the like ad libitum.

Next, a method for forming the heat dissipation layer 14 by a sol-gel method is explained. The composition is prepared by adding a solvent-soluble polymer, a curing catalyst, an organic solvent and the like to a metal alkoxide and/or a hydrolysate thereof ad libitum, and sufficiently kneading. This composition is coated on the surface of the substrate layer 13 by a common coating method, and then dried by heating. The composition is further subjected to an aging treatment or the like to form the heat dissipation layer 14 as a coated and cured film. This heating temperature is appropriately selected depending on the hydrolyzability of the metal alkoxide, and the heat resistance of the substrate layer 13, which temperature is preferably 50°C or higher and 120°C or lower. The polymerize reaction may be carried out in the presence of an inert gas, or under a reduced pressure. Moreover, the polymerization may be allowed while removing alcohols produced as the hydrolytic polymerization proceeds.

In the method for forming the heat dissipation layer 14 by a sol-gel method, it is preferred to subject the composition to ultraviolet irradiation in the heating step. By thus subjecting the composition to ultraviolet irradiation in the heating step of the sol-gel method, the composition is cured at a lower temperature (no higher than 100°C), and defects of the heat dissipation layer 14 are significantly reduced with superior film physical properties and improved adhesiveness between the heat dissipation layer 14 and the substrate layer 13. Thus, the heat dissipation property and gas barrier property of the heat dissipation layer 14 can be further enhanced.

Moreover, for improving the coherent adhesiveness and the like between the substrate layer 13 and the heat dissipation layer 14, the vapor deposited face of the substrate layer 13 may be subjected to a surface finishing treatment. Examples of such a surface finishing treatment for improving the adhesion properties include e.g., (a) a corona discharge treatment, an ozone treatment, low-temperature plasma treatment using an oxygen gas, a nitrogen gas or the like, a glow discharge treatment, oxidizing treatments using a chemical or the like, (b) a primer coating treatment, an undercoating treatment, an anchor coating treatment, a vapor deposition anchor coating treatment, and the like. Among these surface finishing treatments, the corona discharge treatment and the anchor coating treatment are preferred which achieve enhancement of the adhesive strength to the heat dissipation layer 14, and are responsible for formation of compact and uniform heat dissipation layer 14.

Examples of the anchor coating agent which may be used in the aforementioned anchor coating treatment include e.g., polyester-based anchor coating agents, polyamide-based anchor coating agents, polyurethane-based anchor coating agents, epoxy-based anchor coating agents, phenol-based anchor coating agents, (meth)acrylic anchor coating agents, polyvinyl acetate-based anchor coating agents, polyolefin-based anchor coating agents such as those including polyethylene or polypropylene as the base, cellulose-based anchor coating agents, and the like. Among these anchor coating agents, polyester-based anchor coating agents which can further enhance the adhesive strength between the substrate layer 13 and the heat dissipation layer 14 are particularly preferred.

The lower limit of the amount of coating of the aforementioned anchor coating agent (calculated based on the solid content) is preferably 0.1 g/m², and particularly preferably 1 g/m². In contrast, the upper limit of the amount of coating of the anchor coating agent is preferably 5 g/m², and particularly preferably 3 g/m². When the amount of coating of the anchor coating agent is less than the aforementioned lower limit, the effect of improving the adhesion properties between the substrate layer 13 and the heat dissipation layer 14 may be decreased. To the contrary, when the amount of coating of the anchor coating agent is greater than the aforementioned upper limit, strength, durability and the like of the heat dissipation sheet 11 for the back face of a solar battery module may be deteriorated.

In the anchor coating agent described above, can be blended a variety of additives such as a silane coupling agent for improving coherent adhesiveness, an antiblocking agent for preventing blocking with the substrate layer 13, an ultraviolet ray-absorbing agent for improving weather resistance, and the like. The amount of the blending such additives is preferably 0.1% by weight or more and 10% by weight or less in light of the balance of the effect exhibited by the additive, and possible inhibition of the function to be performed by the anchor coating agent.

Moreover, another face (face on the external side not brought into contact with the substrate layer 13) of the heat dissipation layer 14 may be subjected to a top coating treatment. By thus subjecting the external surface of the heat dissipation layer 14 to a top coating treatment, the heat dissipation layer 14 can be sealed and protected. As a result, handleability of the heat dissipation sheet 11 is improved and deterioration of the gas barrier properties is suppressed even if the heat dissipation layer 14 has defects such as scratches and recessed parts, and further aged deterioration of the heat dissipation layer 14 can be inhibited.

Examples of top coating agent used for the top coating treatment include e.g., polyester-based top coating agents, polyamide-based top coating agents, polyurethane-based top coating agents, epoxy-based top coating agents, phenol-based top coating agents, (meth)acrylic top coating agents, polyvinyl acetate-based top coating agents, polyolefin-based top coating agents such as polyethylene or polypropylene, cellulose-based top coating agent, and the like. Among such top coating agents, polyester-based top coating agents that exhibit high adhesion strength with the heat dissipation layer 14, and are responsible for surface protection, defect prevention, and the like of the heat dissipation layer 14 are particularly preferred.

The lower limit of the amount of coating of the top coating agent (on the solid content basis) is preferably 1 g/m², and particularly preferably 3 g/m². On the other hand, the upper limit of the amount of coating of the top coating agent is preferably 10 g/m², and particularly preferably 7 g/m². When the amount of coating of the top coating agent is less than the lower limit described above, the effect of sealing and protecting the heat dissipation layer 14 may be inferior. On the other hand, even if the amount of coating of the top coating agent exceeds the upper limit, the effect of sealing and protecting the heat dissipation layer 14 is less likely to be enhanced, and rather leads to increase in thickness of the heat dissipation sheet 1, whereby the heat dissipation property is impaired, and still further results contrary to demands for reduction in thickness and weight saving may be produced.

It is to be noted that various types of additives such as a silane coupling agent for improving contact adhesion properties, an ultraviolet ray absorbing agent for improving weather resistance etc., an inorganic filler for improving heat resistance etc., may be mixed ad libitum in the top coating agent. The amount of mixing such additives is preferably 0.1% by weight or greater and 10% by weight or less in light of the balance between development of effects of the additive, and inhibition of functions of the top coating agent.

The lower limit of the surface roughness (Ra) of the heat dissipation layer 14 is preferably 1 µm, and particularly preferably 10 µm. On the other hand, the upper limit of the surface roughness (Ra) of the heat dissipation layer 14 is preferably 1 mm, and particularly preferably 100 µm. Although this surface roughness is similar to that of the substrate layer 13, the acceptable range is different as described above since the average thickness of the heat dissipation layer 14 is negligibly thin with respect to the surface roughness of the substrate layer 13. By the heat dissipation layer 14 having a surface roughness falling within the above range, the surface area increases, and thus the heat dissipation effect is significantly improved.

According to the heat dissipation sheet 11 for the back face of a solar battery module, since the heat dissipation layer 14 is provided vapor deposition of inorganic oxide or aluminum or a sol-gel method in this manner, the heat dissipation property can be improved by diffusing the heat locally generated from the solar battery cell, etc., to the entire surface of the sheet due to a high thermal conductivity of the inorganic oxide. In addition, since the heat dissipation layer 14 including an inorganic substance has a superior water vapor barrier function, improvement of resistance to hydrolysis is enabled, and extension of useful life of the solar battery module can be achieved. Furthermore, the heat dissipation sheet 11 for the back face of a solar battery module has a large surface area due to having a fine bumpy shape on another face of the heat dissipation film 2 (the surface of the heat dissipation layer 14), thereby capable of enhancing the heat dissipation efficiency. Moreover, when heat dissipation layer 14 includes an inorganic oxide having insulation property in the heat dissipation sheet 11 for the back face of a solar battery module, the insulation property of the solar battery module can be improved, and thus protection of portions having electric conductivity such as solar battery cells and wirings is enabled.

The heat dissipation sheet 21 for the back face of a solar battery module shown in Fig. 3 includes a heat dissipation film 22, and an adhesive compound layer 3 laminated on one face side of the heat dissipation film 22. Since the adhesive compound layer 3 is similar to that in the heat dissipation sheet 1 for the back face of a solar battery module shown in Fig. 1, explanation of the same will be omitted through designating the identical number.

The heat dissipation film 22 includes a substrate layer 4 in which the adhesive compound layer 3 is laminated on one face side thereof, and a heat dissipation layer 24 laminated on another face side of the substrate layer 4 via a binding agent layer 23. Since the substrate layer 4 is similar to that of the heat dissipation sheet 1 for the back face of a solar battery module shown in Fig. 1, explanation thereof will be omitted through designating the identical number.

Although the binding agent that constitutes the binding agent layer 23 is not,particularly limited, an adhesive for lamination or a melt-extruded resin is suitably used. Examples of the adhesive for lamination include e.g., adhesives for dry lamination, adhesives for wet lamination, adhesives for hot melt lamination, adhesives for nonsolvent lamination and the like. Among these adhesives for lamination, adhesives for dry lamination are particularly preferred which are excellent in the adhesive strength, durability, weather resistance and the like, and have the sealing and protecting functions to compensate for defects (for example, scratch, pinhole, recessed part and the like) of the surface of the substrate layer 4.

Examples of the adhesive for dry lamination include e.g., polyvinyl acetate-based adhesives, polyacrylic ester-based adhesives consisting of a homopolymer of an ethyl, buty,2-ethylhexyl ester or the like of acrylic acid, or a copolymer of the homopolymer and methyl methacrylate, acrylonitrile, styrene or the like, cyano acrylate-based adhesives, ethylene copolymer-based adhesives consisting of a copolymer of ethylene and a monomer such as vinyl acetate, ethyl acrylate, acrylic acid, methacrylic acid or the like, cellulose-based adhesives, polyester-based adhesives, polyamide-based adhesives, polyimide-based adhesives, amino resin-based adhesives consisting of an urea resin, a melamine resin or the like, phenol resin-based adhesives, epoxy-based adhesives, polyurethane-based adhesives, reactive (meth)acrylic adhesives, rubber-based adhesives consisting of a chloroprene rubber, a nitrile rubber, a styrene-butadiene rubber or the like, silicone-based adhesives, inorganic adhesives consisting of alkali metal silicate, low-melting point glass or the like. Among these adhesives for dry lamination, polyurethane-based adhesives, particularly polyester urethane-based adhesives are preferred which prevent the heat dissipation sheet 21 for the back face of a solar battery module from decrease in the adhesive strength and from delamination caused by the long-term use out of doors, and which suppress deterioration such as yellowing and the like of the binding agent layer 23. Meanwhile, aliphatic polyisocyanate accompanied by less thermal yellowing is preferred as a curing agent.

As the melt extruded resin one or two or more thermoplastic resin(s) such as, for example, polyethylene-based resins, polypropylene-based resins, acid modified polyethylene-based resins, acid modified polypropylene-based resins, ethylene-acrylic acid or methacrylic acid copolymers, SURLYN-based resins, ethylene-vinyl acetate copolymers, polyvinyl acetate-based resins, ethylene-acrylic ester or methacrylic ester copolymers, polystyrene-based resins, polyvinyl chloride-based resins and the like can be used. When the extrusion lamination method is employed in which the melt extruded resin is used, it is desired that the opposing face to the lamination of each film described above is subjected to the aforementioned surface finishing treatment such as anchor coating treatment or the like for achieving more rigid adhesion strength.

The lower limit of the amount of lamination of the binding agent layer 23 (calculated based on the solid content) is preferably 1 g/m², and particularly preferably 3 g/m². On the other hand, the upper limit of the amount of lamination of the binding agent layer 23 is preferably 20 g/m², and particularly preferably 10 g/m²*.* When the amount of lamination of the binding agent layer 23 is smaller than the aforementioned lower limit, adhesion strength may not be attained, and a gap is generated between the heat dissipation layer 24 and thus the thermal conductivity and heat dissipation effect may be deteriorated. To the contrary, when the amount of lamination of the binding agent layer 23 is greater than the aforementioned upper limit, strength and durability of the laminated layer may be deteriorated.

In the adhesive for lamination or the melt extruded resin for forming the binding agent layer 23 may be blended a variety of additives ad libitum such as e.g., a solvent, a lubricant, a crosslinking agent, an antioxidant, an ultraviolet ray-absorbing agent, a light stabilizer, a filler, a reinforcing fiber, a strengthening agent, an antistatic agent, a fire retardant, a flame retardant, a foaming agent, an fungicide, a pigment and the like for the purpose of improving and modifying the handleability, heat resistance, weather resistance, mechanical properties and the like.

A metal foil provided with a fine bumpy shape is used for the heat dissipation layer 24. The material entity of the metal foil may include aluminum, aluminum alloy, copper, steel, stainless steel, and the like, and is preferably aluminum or an aluminum alloy and particularly preferably an aluminum-iron-based alloy (soft material). The iron content in the aluminum-iron-based alloy is preferably no less than 0.3% and no greater than 9.0%, and particularly preferably no less than 0.7% and no greater than 2.0%. When the iron content is less than the lower limit described above, an effect of preventing generation of pinhole may be insufficient. To the contrary, when the iron content exceeds the upper limit described above, the flexibility is inhibited, and the processibility may be deteriorated. Furthermore, as the material of the metal foil, soft aluminum subjected to an annealing treatment is also preferred in light of prevention of the pinhole generation.

The lower limit of the thickness (average thickness) of the metal foil is preferably 6 µm, and particularly preferably 15 µm. On the other hand, the upper limit of the thickness of the metal foil is preferably 50 µm, and particularly preferably 30 µm. When the thickness of the metal foil is less than the lower limit described above, breaking of the metal foil is likely to occur during the processing, and the gas barrier properties may be deteriorated resulting from the pinhole and the like. On the other hand, when the thickness of the metal foil is greater than the upper limit described above, cracks and the like may be generated during the processing, and the thickness and the weight of the dissipation sheet 21 for the back face of a solar battery module increase, whereby results contrary to social demands for thin and light modeling may be produced.

In light of prevention of dissolution and corrosion, the surface of the metal foil may be subjected to a surface treatment such as, for example, a chromate treatment, a phosphate treatment, or a lubricating resin-coating treatment. Moreover, in light of acceleration of the adhesion properties, the surface of the metal foil may be subjected to a coupling treatment and the like.

The fine bumpy shape formed on the metal foil may be provided by emboss processing or the like after the metal foil was laminated on the surface of the binding agent layer 23, or a metal foil which had been provided with a fine bumpy shape may be laminated on the surface of the binding agent layer 23.

The lower limit of the surface roughness (Ra) of the heat dissipation layer 24 is preferably 1 µm, and particularly preferably 10 µm. On the other hand, the upper limit of the surface roughness (Ra) of the heat dissipation layer 24 is preferably 1 mm, and particularly preferably 100 µm. When the surface roughness of the heat dissipation layer 24 is smaller than the lower limit described above, the surface area is enlarged insufficiently, and thus improvement of the heat dissipation function by providing a bumpy shape may not be satisfactorily achieved. To the contrary, when the surface roughness of the heat dissipation layer 24 exceeds the upper limit described above, the appearance of glare is caused due to roughening of the surface, and the surface becomes more likely to be scratched.

In addition, the front face (the face on the side not brought into contact with the binding agent layer 23) of the metal foil that is provided as the heat dissipation layer 24 is preferably subjected to a top coating treatment similarly to the heat dissipation layer 14 of the heat dissipation sheet 11 for the back face of a solar battery module. By thus subjecting the front face of the heat dissipation layer 24 to a top coating treatment, the heat dissipation layer 24 is sealed and protected, and consequently, handleability of the dissipation sheet 21 is improved. In addition, even if there are defects such as scratches and recessed parts in the heat dissipation layer 24, deterioration of the gas barrier properties can be suppressed, and further aged deterioration of the heat dissipation layer 24 can be inhibited.

According to the heat dissipation sheet 21 for the back face of a solar battery module, because the heat dissipation layer 24 is a metal foil, the heat dissipation function can be enhanced by diffusing the heat locally generated from solar battery cells, etc., to the entire surface of the sheet by way of an extremely high thermal conductivity of the metal foil. In addition, since the heat dissipation layer composed of a metal foil has a superior water vapor barrier function, the hydrolysis resistance can be improved. Moreover, the heat dissipation sheet 21 for the back face of a solar battery module has a wide surface area since a bumpy shape is provided on the front face, thereby capable of exerting an extremely superior heat dissipation function

In these heat dissipation sheets 1, 11 and 21 for the back face of a solar battery module, one face (the face on the side not brought into contact with the substrate layer) of the adhesive compound layer 3 is preferably covered with a release sheet. Since the heat dissipation sheet for the back face of a solar battery module is covered with the release sheet on one face, the adhesive compound layer can be prevented from contact with other substance by immediately before the operation of attachment, and thus the workability is improved, and the adhesion function of the heat dissipation sheet in attaching can be enhanced.

Although the release sheet is not particularly limited, an appropriate film material constituted with a film of a synthetic resin such as polyethylene, polypropylene, an ethylene-vinyl acetate copolymer, an ethylene-vinyl alcohol copolymer or polyethylene terephthalate, a rubber sheet, paper, a cloth, a nonwoven fabric, a net, an expanded sheet, a metal foil or a laminate thereof, or the like may be used. The surface of the release sheet is preferably subjected to a releasability-imparting treatment such as a silicone treatment, a long-chain alkyl treatment or a fluorine treatment as needed in order to improve release characteristics from the adhesive compound layer 3. The release characteristics of the release sheet can be controlled by regulating the type and/or the amount of coating etc., of the reagent used for the releasability-imparting treatment.

The solar battery module 31 shown in Fig. 4 includes a translucent substrate 32, a first filler layer 33, a plurality of solar battery cells 34, a second filler layer 35, as well as a back sheet 36, and the heat dissipation sheet 1 for the back face of a solar battery module laminated in this order from the front face side. A part of the back face of the back sheet 36 is provided with a junction box 38 having two terminals of a wiring 37 that connects each solar battery cell 34.

The translucent substrate 32 is to be laminated on the frontmost face, and requires: a) to have transmittivity of sunlight, and electrical insulation property b) to be excellent in mechanical, chemical and physical strength, specifically, in weather resistance, heat resistance, durability, water resistance, gas barrier properties against water vapor and the like, wind blast resistance, chemical resistance, and toughness; and c) to have high surface hardness, and to be excellent in antifouling properties to prevent the surface from fouling, accumulation of dirt and the like.

As the material for forming the translucent substrate 32, glass or a synthetic resin may be used. Examples of the synthetic resin used in the translucent substrate 32 include e.g., polyethylene-based resins, polypropylene-based resins, cyclic polyolefin-based resins, fluorine-based resins, polystyrene-based resins, acrylonitrile-styrene copolymers (AS resins, acrylonitrile-butadiene-styrene copolymers (ABS resins), polyvinyl chloride-based resins, fluorine-based resins, poly(meth)acrylic resins, polycarbonate-based resins, polyester-based resins such as polyethylene terephthalate and polyethylene naphthalate, polyamide-based resins such as a variety of nylon, polyimide-based resins, polyamideimide-based resins, polyaryl phthalate-based resins, silicone-based resins, polyphenylenesulfide-based resins, polysulfone-based resins, acetal-based resins, polyether sulfone-based resins, polyurethane-based resins, cellulose-based resins, and the like. Among these resins, fluorine-based resins, cyclic polyolefin-based resins, polycarbonate-based resins, poly(meth)acrylic resins or polyester-based resins are particularly preferred.

In the case of the translucent substrate 32 made of a synthetic resin, (a) lamination of a transparent vapor deposition film of an inorganic oxide such as silicon oxide, aluminum oxide or the like on one face thereof by the PVD or CVD method as described above for the purpose of improving the gas barrier properties and the like; and (b) blending a variety of additives such as e.g., a lubricant, a crosslinking agent, an antioxidant, an ultraviolet ray-absorbing agent, an antistatic agent, a light stabilizer, a filler, a reinforcing fiber, a strengthening agent, a fire retardant, a flame retardant, a foaming agent, an fungicide, a pigment and the like for the purpose of improving and modifying the processibility, heat resistance, weather resistance, mechanical properties, dimension accuracy and the like are also acceptable.

The thickness (average thickness) of the translucent substrate 32 is not particularly limited, and may be determined ad libitum such that necessary strength, gas barrier properties and the like are provided depending on the material used. The thickness of the translucent substrate 32 made of the synthetic resin is preferably 6 µm or greater and 300 µm or less, and particularly preferably 9 µm or greater and 150 µm or less. Moreover, the thickness of the translucent substrate 32 made of glass is generally about 3 mm.

The first filler layer 33 and the second filler layer 35 are filled around the solar battery cell 34 between the translucent substrate 32 and the back sheet 36, and have (a) adhesiveness between the translucent substrate 32 and the back sheet 36; and scratch resistance, shock absorbing properties and the like for protecting the solar battery cell 34. The first filler layer 33 laminated on the surface of the solar battery cell 34 has transparency that permits transmission of the sunlight, in addition to the various functions as described above.

Examples of the material for forming the first filler layer 33 and the second filler layer 35 include e.g., fluorine-based resins, ethylene-vinyl acetate copolymer, ionomer resins, ethylene-acrylic acid or methacrylic acid copolymers, acid-modified polyolefin-based resins prepared by modification of a polyolefin-based resin such as a polyethylene resin, a polypropylene resin or polyethylene with an unsaturated carboxylic acid such as acrylic acid, polyvinylbutyral resins, silicone-based resins, epoxy-based resins, (meth)acrylic resins and the like. Among these synthetic resins, fluorine-based resins, silicone-based resins or ethylene-vinyl acetate-based resins that are excellent in the weather resistance, heat resistance, gas barrier properties and the like are preferred.

Moreover, the material which can be used for forming the first filler layer 33 and the second filler layer 35 includes heat reversible crosslinkable olefin-based polymer compositions described in Japanese Unexamined Patent Application Publication No. 2000-34376. More specifically the composition includes (a) a modified olefin-based polymer prepared by modification with unsaturated carboxylic anhydride and unsaturated carboxylate ester, with the average biding number of the carboxylic anhydride group per molecule being one or more, and with the ratio of the number of the carboxylate ester group to the number of the carboxylic anhydride group in the modified olefin-based polymer being 0.5 to 20, and (b) a hydroxyl group-containing polymer having an average binding number of the hydroxyl group per molecule being one or more, in which the ratio of the number of the hydroxyl group in the component (b) to the number of the carboxylic anhydride group in the component (a) is 0.1 to 5, and the like.

In the material for forming the first filler layer 33 and the second filler layer 35 may be blended a variety of additives ad libitum such as e.g., a crosslinking agent, a thermal antioxidant, a light stabilizer, an ultraviolet ray-absorbing agent, a photooxidation inhibitor and the like for the purpose of improving weather resistance, heat resistance, gas barrier properties and the like. Moreover, the thickness of the first filler layer 33 and the second filler layer 35 is not particularly limited, but is preferably 200 µm or greater and 1,000 µm or less, and particularly preferably 350 µm or greater and 600 µm or less.

The aforementioned solar battery cell 34 is a photovoltaic device that converts light energy into electrical energy, and is provided between the first filler layer 33 and the second filler layer 35. A plurality of the solar battery cells 34 are laid on a substantially identical plane, which are wired in series or in parallel. As the solar battery cell 34, for example, crystalline silicon solar cell elements such as single crystalline silicon type solar battery elements, polycrystalline silicon type solar battery elements and the like, amorphous silicon solar battery elements of single joint type, tandem structure type and the like, semiconductor solar cell elements with compounds of groups 3 to 5 such as gallium arsenic (GaAs), indium phosphorus (InP) and the like, compound semiconductor solar cell elements with compounds of groups 2 to 6 such as cadmium tellurium (CdTe), copper indium diselenide (CuInSe₂) and the like can be used, and the hybrid element of the same can be also used. The first filler layer 33 or the second filler layer 35 is also filled between a plurality of the solar battery cells 34 without any gap.

The back sheet 36 protects the solar battery cell 34, and the filler layers 33 and 35 from the back face, and has gas barrier properties against water vapor, oxygen gas etc., in addition to basic performances such as strength, weather resistance and heat resistance. A well-known sheet may be used as the back sheet 36. The back sheet 36 has a multilayer structure in which a pair of synthetic resin layers are laminated on the front face and back face of the gas barrier layer.

The heat dissipation sheet 1 for the back face of a solar battery module is provided to attach on the back face of the back sheet 36 via the adhesive compound layer 3. The heat dissipation sheet 1 for the back face of a solar battery module is cut into a shape in which a portion corresponding to the junction box 38 is excluded.

The method for production of the solar battery module 31 is not particularly limited, but in general, includes (1) a step of superposing the translucent substrate 32, the first filler layer 33, a plurality of the solar battery cells 34, the second filler layer 35 and the back sheet 36 in this order, (2) a step of laminating to perfect integral molding by a vacuum heat lamination method or the like in which they are integrated by vacuum aspiration and heat pressure joining, (3) a step of providing the junction box 38 on the back face of the back sheet 36, and (4) a step of laminating the heat dissipation sheet 1 for the back face of a solar battery module on the back face of the back sheet 36 at a site except for the portion on which the junction box 38 was provided. In the method for production of the solar battery module 31, (a) coating of a heat melt adhesive, a solvent type adhesive, a photocurable adhesive or the like, (b) to the opposing face to the lamination a corona discharge treatment, an ozone treatment, a low-temperature plasma treatment, a glow discharge treatment, an oxidizing treatment, a primer coating treatment, an under coating treatment, an anchor coating treatment or the like can be carried out for the purpose of achieving the adhesiveness between each layer.

It should be noted that the heat dissipation sheet 1 for the back face of a solar battery module may be laminated on the back face (the face on the side of the back sheet 36) of a solar battery module already put into practical use, which includes a translucent substrate 32, a first filler layer 33, multiple solar battery cells 34, a second filler layer 35, and a back sheet 36 laminated in this order from the front face side, and which is provided with junction box 38 having two terminals of a wiring 37 that connects each solar battery cell 34 on the back face of the back sheet 36, or may be laminated in production of the solar battery module.

Since the solar battery module 31 includes the heat dissipation sheet 1 for the back face of a solar battery module as described above, the heat dissipation property of the solar battery module can be improved. As a result, improvement of the efficiency of electric power generation and extension of the useful life can be achieved. In addition, since heat the dissipation sheet for the back face of a solar battery module is attached via the adhesive compound layer 3 in the solar battery module 31, for example, a superior heat dissipation function can be constantly exerted by replacing the heat dissipation sheet 1 for the back face of a solar battery module, even when the heat dissipation film 2 is damaged. Furthermore, lamination to a solar battery module already used (one including a translucent substrate 32, a first filler layer 33, multiple solar battery cells 34, a second filler layer 35, and a back sheet 36 laminated in this order from the front face side, and provided with a junction box 38 that has two terminals of wirings 37 for connecting each solar battery cell 34 to the back face of the back sheet 36) can enhance the heat dissipation efficiency of the preexisting solar battery module, whereby the efficiency of electric power generation can be improved. In addition, even when physical defects such as scratches and cracks are generated in the back face of the back sheet 36, the adhesive compound layer 3 can suppress expansion of the physical defects by way of the heat dissipation sheet 1 for the back face of a solar battery module, and prevent penetration of water vapor, etc., from the physical defect portions, thereby capable of promoting extension of useful life of the solar battery module.

It should be noted that the heat dissipation sheet for the back face of a solar battery module of the present invention and a solar battery module using the same are not limited to the foregoing embodiments. For example, the solar battery module may include any of the heat dissipation sheets 11, 21 for the back face of a solar battery module and other heat dissipation sheet for the back face of a solar battery module laminated, other than the heat dissipation sheet 1 for the back face of a solar battery module.

Also, in the heat dissipation sheet for the back face of a solar battery module in which the heat dissipation layer is an inorganic oxide or aluminum, the front face may not be provided with the fine bumpy shape. Since an inorganic oxide or aluminum has a high thermal conductivity, a heat dissipation effect can be exerted even if the surface area is not enlarged by providing the bumpy shape on the front face, owing to this heat dissipation film by diffusing the heat locally generated to the entire surface of the sheet.

Similarly, also in the heat dissipation sheet for protecting the back face of a solar battery module in which the heat dissipation layer includes fine particles, and a binder for the fine particles, the fine bumpy shape may not be provided on the front face. Also in such a heat dissipation sheet for protecting the back face of a solar battery module, the heat dissipation effect can be exerted by diffusing the heat locally generated to the entire surface of the sheet since the fine particles have a high thermal conductivity, and contained densely such that each fine particle is in contact one another.

Alternatively, the heat dissipation film may not have a two-layer structure including the substrate layer and the heat dissipation layer, but have a monolayer structure. More specifically, for example, a structure without including the heat dissipation layer in the heat dissipation sheet 11 for the back face of a solar battery module shown in Fig. 2 is acceptable. Also in such a heat dissipation sheet for the back face of a solar battery module, the entire surface of the front face (another face) of the substrate layer, i.e., the heat dissipation film has a fine bumpy shape; therefore, the surface area increases, and a superior heat dissipation property is achieved, and thus a function as a heat dissipation sheet can be sufficiently exerted. In addition, as an example in which the heat dissipation film has a single layer, the heat dissipation film may have a structure composed of a metal foil alone. Even if the heat dissipation sheet for the back face of a solar battery module has such a structure, a heat dissipation function can be exerted owing to a high thermal conductivity of the metal foil.

### INDUSTRIAL APPLICABILITY

As in the foregoing, the heat dissipation sheet for the back face of a solar battery module of the present invention improves the heat dissipation effect of a solar battery module, and enhances the efficiency of electric power generation. In addition, deterioration of the solar battery cells, etc., is prevented and use for a long period of time is permitted; therefore, the heat dissipation sheet can be used as a sheet to be stuck on the back face of a solar battery module. In particular, the present heat dissipation sheet can be suitably used for solar battery modules and the like installed outdoors subjected to severe environments in use.

### [Explanation of the Reference symbols]

1 heat dissipation sheet for the back face of a solar battery module
2 heat dissipation film
3 adhesive compound layer
4 substrate layer
5 heat dissipation layer
6 fine particles
7 binder
8 bumpy shape
11 heat dissipation sheet for the back face of a solar battery module
12 heat dissipation film
13 substrate layer
14 heat dissipation layer
21 heat dissipation sheet for the back face of a solar battery module
22 heat dissipation film
23 binding agent layer
24 heat dissipation layer
31 solar battery module
32 translucent substrate
33 first filler layer
34 solar battery cell
35 second filler layer
36 back sheet
37 terminal
38 junction box

## Claims

1. A heat dissipation sheet for the back face of a solar battery module comprising a heat dissipation film, and an adhesive compound layer laminated on one face side of the heat dissipation film.

2. The heat dissipation sheet for the back face of a solar battery module according to claim 1, wherein the heat dissipation film has a fine bumpy shape on the entire surface of another face.

3. The heat dissipation sheet for the back face of a solar battery module according to claim 1, wherein the heat dissipation film comprises
a substrate layer in which the adhesive compound layer is laminated on one face side, and
a heat dissipation layer laminated on another face side of the substrate layer.

4. The heat dissipation sheet for the back face of a solar battery module according to claim 3, wherein the heat dissipation layer comprises fine particles, and a binder for the fine particles.

5. The heat dissipation sheet for the back face of a solar battery module according to claim 4, wherein the fine particles are at least one type of beads selected from metal beads and inorganic oxide beads.

6. The heat dissipation sheet for the back face of a solar battery module according to claim 3, wherein the heat dissipation layer comprises a vapor-deposited inorganic oxide.

7. The heat dissipation sheet for the back face of a solar battery module according to claim 3, wherein the heat dissipation layer is a metal foil.

8. The heat dissipation sheet for the back face of a solar battery module according to claim 1 further comprising a release sheet covering one face of the adhesive compound layer.

9. A solar battery module comprising: a transparent substrate; a first filler layer; solar battery cells as a photovoltaic device; a second filler layer; a back sheet; and a heat dissipation sheet for the back face of a solar battery module, laminated in this order from the front face side,
wherein the heat dissipation sheet for the back face of a solar battery module comprises a heat dissipation film, and an adhesive compound layer laminated on one face side of the heat dissipation film, and is attached via the adhesive compound layer thereof on the back face of the back sheet.
